# EUROPEAN PATENT SPECIFICATION

(11) **EP 4 113 352 B1**
(45) Date of publication and mention of the grant of the patent: **26.03.2025**
(21) Application number: 21183476.7
(22) Date of filing: 02.07.2021
(51) Int. Cl.: G06F 30/34, G06F 30/36, G06F 30/27

(54) **A METHOD FOR IMPROVING DIGITAL SIGNAL PROCESSING IN A RADIO-FREQUENCY SYSTEM**
VERFAHREN ZUR VERBESSERUNG DER DIGITALEN SIGNALVERARBEITUNG IN EINEM HOCHFREQUENZSYSTEM
PROCÉDÉ POUR AMÉLIORER LE TRAITEMENT DE SIGNAUX NUMÉRIQUES DANS UN SYSTÈME DE FRÉQUENCE RADIO

(43) Date of publication of application: 04.01.2023
(73) Proprietor: Comet AG, 3175 Flamatt (CH)
(72) Inventor: Schwerg, Nikolai, 3033 Wohlen bei Bern (CH); Schlierf, Roland, 50226 Frechen (DE); Grede, André, 1700 Fribourg (CH); Gruner, Daniel, 79410 Badenweiler (DE); Labanc, Anton, 79238 Ehrenkirchen (DE); Fink, Thomas, 5603 Staufen (CH); vor dem Brocke, Manuel, 49565 Bramsche (DE)
(74) Representative: dompatent von Kreisler Selting Werner - Partnerschaft von Patent- und Rechtsanwälten mbB

(56) References cited:
- US-A1- 2001 018 762
- US-A1- 2006 262 889
- US-A1- 2016 012 171
- US-A1- 2016 147 916

## Description

The present invention relates to a method for improving digital signal processing in a radio-frequency system. Furthermore, the invention relates to a radio-frequency power delivery system or a radio-frequency plasma system.

### Background and prior art

Digital signal processing, short "DSP", can be used in a radio-frequency system for various applications such as filtering and/or detection of specific situations of the system. To improve processing and performance speed, DSP can be carried out at least partially in hardware, e.g., by integrated circuits, short "IC". However, parametrization of integrated circuits can prove to be time-consuming and technically complex. Said complexity of the parametrization process can affect the digital signal processing in many undesired ways. One of them is a partial reduction of the DSP efficiency in integrated circuits.

In a plasma power delivery system, the radio frequency, short RF, signals can be measured. Typical RF measurements include forward and reverse power, as well as RF current and voltage at various points within the plasma power delivery system. The measured signals may generally vary in frequency, amplitude, noise or spurious content and pulse length. While some variations such as frequency may be under good control of the power delivery system, other variations may be uncontrolled, especially when delivering RF power to plasma processing chambers. Variations can lead to various kinds of interferences found in the measured RF signals. Harmonics, as one form of interference for example, may be generated due to the non-linear nature of the plasma itself. Another form of interference may result from different frequencies that are used for the generation of the RF signal. In advanced plasma systems, several RF generators with different frequencies may be used for plasma excitation. However, in addition to the desired production of the intended set of frequencies also mixing products like additive or subtractive combinations of the base frequencies and their harmonics may be produced.

Many interferences found in the measured RF signal can be suppressed or at least reduced by using appropriate filters prior to digitizing the measured RF signal. Nevertheless, unwanted sidebands close to base frequencies can occur which may require further filtering by the DSP and/or may also impose further requirements on the filtering. Real input signals are never ideal since they always contain unavoidable distortions or other artefacts, e. g. caused by the signal source, the transmission path, or the measurement device. The optimization of filters, or filter parameters is important to reconstruct undistorted, ideal input signals for a stable regulation of the network. However, each filter possesses advantageous and disadvantageous characteristics. For example, if a signal delay due to the filtering increases too much, a control can no longer respond in a timely manner to deviations from an intended power level. Therefore, not only the filter type but also its parameter configuration needs to be carefully selected in order to balance these characteristics for an optimized performance.

In general, the insufficient reduction of interferences may cause fluctuations in the measurement of the output power of an RF generator. These fluctuations can be understood as "measurement artefacts". Since the measurement may be used for various applications like the control of the output power level, these applications may rely on a compromised measurement signal. Regarding the example of control, the output power level may wrongly follow the measurement artefacts instead of a correct measurement.

US 20060262889 A1 discloses a power source that may generate signals, when driven by a drive signal from a controller. At radio frequencies, either synchronous undersampling or synchronous oversampling may be the case.

In DE102015212242A1 / US20180122625A1 the sampling frequency is varied to remove interference.

Both publications describe a specific method to correct for interfering frequencies which includes adaptation of the sampling frequency, but not the optimization of filter parameters by machine learning, particularly by the machine learning procedure.

It is further known from prior art that intelligent systems for the detection of specific situations during a plasma process exist. However, the detection often lacks reliability and processing speed to initiate a corrective action prior to the completion of the event in time.

The use of dedicated solutions for detection of specific situations in plasma processes has been reported in prior art, for example in US8989888B2.

The general use of programmable circuits, in particular field-programmable gate arrays (FPGAs) for accelerating simulations is known from prior art, e. g. WO2007095574A1 or DE102011103861A1.

Further, US 2016/147916 describes a method and system provided for tuning parameters of a synthesis program for a design description. The method includes (a) ranking individual parameter impact by evaluating a design-cost function of each of the parameters. The method further includes (b) creating a set of possible parameter combinations that is ordered by an estimated-cost function. The method additionally includes (c) selecting, from the set of possible parameter combinations, top-k scenarios having best estimated costs to form a potential set, and running at least some of the top-k scenarios in parallel through the synthesis program. The method also includes (d) repeating steps (b)-(c) for one or more iterations until at least one of a maximum iteration limit is reached and an exit criterion is satisfied.

It is therefore an object of the present invention to at least partially overcome the disadvantages described above. In particular, it is an object of the present invention to improve the digital signal processing in an RF system.

The above-mentioned objective is solved by a method with the features of claim 1, a system with the features of claim 15. Further features and details of the invention are disclosed in the respective dependent claims, the description and the drawings. Features and details described in connection with the method according to the invention also apply to the system according to the invention, and vice versa in each case, so that with respect to the disclosure concerning the individual aspects of the invention references can always be made mutually.

### Advantages of the inventive method and system

In contrast to the previous publications in the prior art, the inventive method, system and carrier signal allow to optimize a digital signal processing, in particular in a radio-frequency system. To this end, it is particularly an idea of the invention that the processing procedure may be used for a training, especially of the inventive system. The training may be performed with reference data in a training mode, such that an optimized parametrization of the programable circuit and/or an algorithm is determined, and then the inventive system may be switched to an application mode in which the optimized parametrization is used for the processing of input signals related in real time. The programmable circuit may be a programmable signal processing circuit like a FPGA for the processing of the input signals by carrying out the algorithm.

Further advantages of the inventive method, system and carrier signal over prior art may also be achieved by executing the training and the real-time modes of operation on the same system. Moreover, further training with new sets of training data, i. e. a machine-learning of new situations, can advantageously be performed at a later point of time, and an already existing parametrization can be optimized further (in the following, this is particularly referred to as a "switching the processing from the real-time mode to the training mode"). In addition, the transfer of optimized parametrizations to other systems of the same kind is possible, for example by using a user interface.

Advantageously, the use of the same hardware components (FGPA, control, memory) both for training and application mode facilitates the transfer of parametrizations between systems and enables future upgrades of a plasma process system for new situations which are not known yet. The training can, for example, be performed on a test bench system or a laboratory plasma processing system with pre-existent input signals which have been recorded on a system which is in use in the field. The variability of these signals can be numerically increased by scaling, filtering, superposition, etc. Then, the optimized parametrization can easily be transferred from the training system to the plasma processing system in the field.

Moreover, by using pre-existent input signals from the memory, the functionality of an RF system in a wide variety of situations can be tested, for example in a factory acceptance test of the RF system. In this case, the input signals are supplied by means of the memory instead or in combination with the ADC data, and the system behavior, such as the performance of regulation loops, filtering of RF signals, pattern recognition as well as any response actions e. g. warnings or interlocks can be verified with a fully operational system.

### Description of the invention

The objective is particularly solved by a method for improving digital signal processing, preferably in a radio-frequency system, in particular a radio-frequency power delivery system, comprising (particularly executed one after the other or in any order):
- Providing at least one input signal, preferably related to a radio-frequency signal of the radio-frequency system and/or to a signal from a plasma chamber and/or to an optical signal measured in the radio-frequency system and/or to a signal of an external source,
- Performing a processing procedure, wherein the at least one input signal is repeatedly processed by a circuit, preferably a programmable circuit, using at least one configurable parameter of the processing, wherein a configuration of the at least one parameter is varied, particularly modified, for each processing of the at least one input signal to obtain respective processing results,
- Determining at least one parameter result, particularly comprising a selection of the varied configurations, for an optimization of the configuration based on the processing results,
- Providing the at least one determined parameter result for the improved digital signal processing, particularly for the parametrization of the circuit using the selection.

The method according to the invention has the advantage that multiple processing results can be made available, each specific to the configuration of the parameters being used, so that the best configuration may be selected from the varied configurations based on the processing results. In other words, the parameter can be optimized by varying the configuration (also referred to as "varying the parameter"). The selection of the parameter result may therefore comprise at least one of the varied configurations which led to the best processing result within the processing procedure. The usage of the parameter result for the parameterization of the circuit can achieve an improvement of the digital signal processing (DSP).

The processing procedure may comprise the repeated processing, particularly digital signal processing, by the circuit, but also further steps like an evaluation and/or the variation of the configuration as particularly explained in more detail below. Furthermore, the processing procedure may be regarded, as least partly, as a machine learning procedure. In other words, the processing procedure may comprise the machine learning procedure. The machine learning procedure may comprise (at least) the evaluation and/or a storage of the determined parameter result in a memory and/or the determining and/or providing of the parameter result and/or the learning and/or optimizing of the configuration, preferably of a parameter value and/or at least one weight of a neural network.

In the context of the disclosure of the invention, indefinite and definite articles or numerical indications, e.g. "one", "two", etc.", are to be understood as "at least" indications, unless expressly stated otherwise. Even from the explicit indication of "at least" or similar, it must not be concluded that a restriction, e.g. in the sense of "exactly one", is to be implied by another simple use of the article or the numerical indication without this explicit indication. Furthermore, numerical indications as well as indications of process parameters and/or device parameters are to be understood in the technical sense, i.e. as having the usual tolerances.

The use of the term "best processing result" can refer to:
- an optimum result of the digital signal processing, e. g. the maximum suppression of unwanted frequencies,
- an optimum result for a measured parameter which is related to the RF power delivery system, e. g. an RF power output with lowest variation,
- an optimum detection of a specific pattern in one of the measured signals,
- an optimum result for a measured parameter which is related to the plasma process, e. g. a DC self-bias or an ion concentration,
- an optimum result for a measured parameter which is related to a property of the item processed in the plasma process chamber, e. g. a thickness of a deposited layer.

The performing of the processing procedure may be initiated and controlled by a control circuit (also referred to as "control" in the following) that is electrically connected to the programmable circuit to provide the at least one input signal. Furthermore, the determining and providing may be also carried out by the control circuit.

The term "digital signal processing" is generally understood to mean a processing of a digital signal. Specifically, the digital signal processing according to the invention may comprise the processing of an RF signal after it has been sensed by at least one sensor and subsequently converted to a digital signal by an analog-to-digital converter, short ADC, of the RF system in real-time. In contrast to the digital signal processing, a "processing procedure" may be considered as a training procedure that does not use an input signal that is actually sensed in real-time (instead, it may be previously recorded or computer simulated). The algorithm used for the processing within the processing procedure and within the digital signal processing may be the same. However, the configuration of the algorithm is at first trained within the processing procedure and only afterwards applied within the digital signal processing.

The term "RF system" refers to a system that outputs at least one electrical RF signal. Furthermore, the RF system may comprise or may be a part of an RF generator. The term radio-frequency power delivery system, which may be a concrete configuration of the RF system, refers to an electrical power supply for a plasma system, particularly for a plasma generator system. The plasma system may be suitable to generate plasma used for plasma processing, preferably plasma etching or plasma deposition As is well-known to those skilled in the art, plasma processing applications are typically powered with (amplified) power signals of 100 W or more, often also in excess of 1 kW signals, in order to appropriately ionize the gases and produce plasma in the plasma processing chamber. However the control signals involved in controlling those high power signals may involve much lower power signals and may be processed according to low power signal processing techniques. Sensing a property of the high-power signal may involve various type of sensors and may involve picking-up a characteristic quantity of that signal, including a small fraction of the amplitude of the high-power signal.

The "at least one input signal" may be a digital signal that is preferably related to a radio-frequency signal of the radio-frequency system. Particularly, this means that the at least one input signal may be specific for the RF signal and/or obtained by sensing, particularly measuring, the RF signal. The RF signal may therefore be a physical signal in the radio frequency range that is an actual electrical output of or within the RF system. The RF range can be the frequency range from 20 kHz to 300 GHz, preferably from 300 kHz to 300 MHz (medium frequency band, high frequency band and very high frequency band. It is also possible for the input signal to be a DC signal which is derived from an RF signal and which can vary at a low frequency, e. g. in pulsing applications, for example a measured DC bias voltage, which is present in the plasma chamber, a measured forward and/or reflected power, a reflection coefficient, a phase between an RF voltage and current, or a scalar signal from an external sensor.

Particularly, the RF range may also be in the range from 300 kHz to 500 kHz or from 1 MHz to 3 MHz or from 10 MHz to 16 MHz or from 24 MHz to 30 MHz or from 37 MHz to 43 MHz or from 57 MHz to 63 MHz or from 77 MHz to 83 MHz or from 159 to 165 MHz. For example, in the RF range from 10 MHz to 16 MHz, a particular frequency of the radio-frequency signal may be 13.56 MHz. The mentioned frequency ranges are particularly used in plasma application and/or for RF-generators.

Within the processing procedure, the at least one input signal is repeatedly processed by the circuit. The circuit may be suitable to carry out an algorithm for the processing of the at least one input signal depending on the configuration of the at least one parameter. The parameter therefore may be a parameter of the algorithm. In case of a filtering, the algorithm can be a filter algorithm and the parameter can be a filter parameter and/or filter coefficient. Furthermore, the circuit may be suitable to apply a neural network. **In** this case, the parameter may be at least one weight of the neural network. The circuit may be programmable at least in the sense that the configuration of the at least one parameter can be changed.

The "repeated processing" may be understood to mean a repeated processing of the same at least one input signal using the same algorithm but different configurations. Therefore, the configuration of the at least one parameter is varied for each processing of the at least one input signal to obtain the respective processing results. The respective processing results may in other words be the respective results of the algorithm when carried out with their respective configuration.

Advantageously, the at least one parameter may be a processing parameter that influences the processing result. In the case that the processing comprises a filtering of the at least one input signal, the at least one parameter may comprise at least one filter parameter. For example, the at least one parameter can comprise an adjustable cut-off frequency and/or a threshold and/or the like.

The "determining the at least one parameter result" can be understood as a selection of at least or exactly one of the varied configurations that led to the best processing result (and is therefore based on the processing results). This allows for an optimization of the parameter configuration. The "providing the at least one determined parameter result for the improved digital signal processing" may be understood as a parametrization of the circuit using the selected configuration.

The parameter result may comprise a specific configuration selected from the varied configurations, wherein the selection may take place depending on the processing results. For example, a reference can be provided like a metric or reference result that is used to evaluate each of the processing results. Each of the processing results corresponds to a configuration that has been used to obtain this processing result. In consequence, each of the processing results can be used to evaluate, particularly rate, the configuration. Therefore, the exact configuration may be selected which corresponds to the best evaluated or best rated processing result. In other words, the configuration is optimized so that the difference between the corresponding processing result and the reference is minimized. The "optimization of the configuration" may also be referred to as an "optimization of the at least one parameter", wherein the at least one optimized parameter (i.e., the selected configuration) may subsequently be used to parametrize the (or another) programmable circuit for an "in the field" or "real-time" operation or "application mode" of the radio-frequency system. These terms are used synonymously in the following.

The "evaluation" may be understood as a comparison of the processing result with a reference, such as an ideal processing result. The better the processing result and the reference match, the better the evaluation of the corresponding configuration. The evaluation may be performed by the control circuit or by a dedicated part of the programmable circuit. There are many different state-of-the-art methods which can be used for the evaluation, for example statistical methods for signal assessment, multivariate statistical techniques, or empirical comparative time-series analysis.

In an embodiment, the at least one parameter result comprises at least two different parameter results for different applications of the DSP. Alternatively, or additionally, the DSP and the signal processing may comprise a filtering that is parametrized by the configuration. The choice of the configuration of the filtering has a significant influence on the interference reduction at the RF signal. However, one specific configuration might not work for all combinations of RF power levels in a multi-frequency application and possibly, also not for all processes which are run in a plasma chamber of the plasma system. Therefore, there may be a need for determining optimized configurations for different plasma processing conditions. This may be achieved by using multiple parameter results for the different applications. For each application, a different set of input signals may be provided during the training process that can be used separately for the processing procedure and therefore result in the different parameter results.

Depending on the sequence of different process conditions in the steps of a plasma process recipe, fast switching between different configurations may also be advantageous when process conditions are changed, for example during real-time operation. Therefore, it can be possible that the different parameter results are stored in a memory for a fast switching.

Within the digital signal processing and/or the processing procedure, the at least one input signal may be predefined, e. g. by providing an already digitized signal which serves, for example, as training input signal or as a reference input signal. The already digitized signal can be a pre-existent signal, which can be a previously recorded signal or e.g. a simulated signal. Thus, an ADC is not necessarily required for the processing. However, in real-time operations, the ADC may convert the analog sensed RF signal to a digital representation of the signal, hereinafter referred to as real-time input signal. In a training mode, the at least one predefined input signal may be predefined with desired characteristics and features for the processing procedure and therefore only may "represent" the actual radio-frequency signal. However, in a real-time mode, the programmable circuit may process the real-time input signal from the sensed RF signal instead of the predefined input signal.

The RF system may comprise at least one sensor for performing a sensing, particularly measuring, of the RF signal that is used to provide RF power to the plasma system. The measurement may include measuring the RF signal in the form of a forward and reverse power and/or an RF current and/or an RF voltage, particularly at various points within the RF system. It may also be intended that the output power of an RF generator is regulated, and to this end the RF signal, particularly in the form of RF waveforms at the output of the generator, is measured by the sensor. A directional coupler may be used to provide the forward and reverse waveforms to the sensor. The RF signal may therefore be an analog signal, which is subsequently converted by an ADC with a specific sample rate to provide the digital real-time input signal. In a similar way, other sensors, e. g. in an impedance matching network, e. g. a phase-and-magnitude sensor, a voltage-current sensor or a DC bias sensor, or directly at the plasma chamber, e. g. a Langmuir probe or an optical sensor, may measure various parameters like RF voltage and current, DC self-bias of the plasma, or the intensity of specific spectral lines in the plasma spectrum. These measurements are used to control tuneable elements for maximizing the power transfer to the plasma or are used for characterizing the plasma properties. The measured parameters may be provided as a real-time input signals or may be represented as a training input signal.

Depending on the RF frequencies present in the RF signal, aliasing and/or intermodulation effects can occur when the signal is digitized, i.e., converted by the ADC. These effects can include high-frequency components mixing and/or folding back into lower frequency bands depending on the sampling rate and frequency. Furthermore, the mixing and/or folding back into lower bands may vary with pulse modulation and/or frequency tuning of the RF generator. In consequence, the measurement of the delivered RF power at the frequency of operation may be affected, and the feedback regulation of the power generator which depends on this measurement may deliver an incorrect or instable or even varying power level. Similarly, voltage and current measurements may be distorted and may lead to inappropriate responses like instable power output of the RF generator or detuning of the matching network. However, by using the processing by the programmable circuit and particularly filtering, e. g. via appropriate low-pass filters, the problems may be mitigated. For example, by using the filtering, high-frequency components which are above the Nyquist limit (i.e., half of the sampling frequency) can be removed. Unwanted additive or subtractive frequency intermodulation products can be removed, e. g. by suppressing specific frequencies or frequency ranges after transforming the RF signal into the frequency domain, for example by a fast Fourier-transformation. The parameter result hereby may comprise at least one (optimized) configuration for the at least one parameter. In the case of filtering, the configuration may therefore be referred to as filter configuration.

The type and layout as well as the filter coefficients required for most accurate measurement results of the filter after the digitization and/or mixing can vary for amplitude modulated signals, in particular with the specific temporal characteristics of multi-level pulse patterns, e. g. the pulse rise and fall time, power difference between levels, pulse frequency etc. One set of filter coefficients which works for a certain group of pulse patterns, might not be appropriate for a significantly faster or slower pulse pattern. By using individually optimized filter configurations for each pulse pattern, unwanted aliasing and/or intermodulation products can be suppressed for a variety of pulse patterns. In the case of frequency tuning, e. g. for adapting to a varying plasma load and for maximizing the power provided to a plasma system, filter coefficients which depend on the variable base frequency might be needed to obtain accurate measurements and to maintain a stable output power of the RF generator. By implementing the filter components and the optimized parameters in the programmable circuit, i.e., particularly a programmable logic device, e. g. a digital signal processor (DSP), a complex programmable logic device (CPLD), or an FPGA, aliasing and/or intermodulation products may be removed or reduced in real-time. Removing aliasing and/or intermodulation products can only be possible inside the programmable circuit, in particular the FPGA up to a certain degree. Moreover, the implemented filter configuration may quickly be switched to another configuration which is optimized for different operating conditions. In addition, if at a later point of time, an improved filter configuration is developed, it can be easily implemented without any hardware changes. In this context, it is already known that aliasing and/or intermodulation effects are bypassed by sampling the signal in a way that undersampling effects are avoided by adapting the sampling frequency to the signal base frequency. In contrast, the inventive use of specific configurations for the processing, particularly filtering, allows to remove higher frequencies while the base frequency can still be sampled with a sufficiently high rate. Furthermore, the implementation into a programmable circuit allows to quickly switch between different configurations, e.g., depending on the specific application or situation. Optimized parameter sets for a given application case may e.g., be obtained by teaching the system with the at least one training input signal that may comprise reference waveforms, and their expected reference results. The configurable parameters, e. g. the filter parameters, can then be varied until an optimum is reached. It should be noted, that the anti-aliasing filter which is arranged before the ADC is an analog circuit. This anti-aliasing filter can be made variable using controllable analog components, but it can not be implemented in the FPGA.

The at least one input signal may comprise multiple predefined batches of or multiple pre-existing input signals (i. e. previously recorded or e.g. simulated). Each of the input signals can be related to the radio-frequency (RF) signal, i.e., it can be specific to or representative of a real or simulated RF signal. It can also be simply derived from a measured RF signal, for example by generating a digital representation from the measured RF signal Furthermore, each input signal may comprise a pre-known pattern, and a corresponding reference result may indicate this pre-known pattern, which is described in more detail below. The pre-existing input signals can be considered as references or reference signals since they can include specific features and/or provide the corresponding reference result. The optimization of the configuration, i.e., a learning of the optimal parametrization of the programmable circuit, can then be achieved by comparing the reference results with the processing results. The reference results may comprise a target waveform or a target frequency or a desired pattern detection result. The comparison may be achieved by using a suitable metric which indicates the degree of discrepancy between the reference result and the processing result.

After providing the at least one input signal in the form of a batch of input signals, i.e., with (at least) a first input signal and a second input signal, and particularly with at least 10 or 100 or 1000 further input signals, the processing procedure, which can also be referred to as training procedure, can comprise the following processing flow:
- In a first processing step, processing the first input signal using a first configuration, processing the second input signal using the first configuration, and processing the further input signals also using the first configuration, thereby obtaining a first processing result for the first configuration,
- In a second processing step, processing the first input signal using a second configuration, processing the second input signal using the second configuration, and processing the further input signals also using the second configuration, thereby obtaining a second processing result for the first configuration,
- In further processing steps, processing the first input signal using further configurations, processing the second input signal using the further configurations, and processing the further input signals also using the further configuration, thereby obtaining corresponding processing results for each of the further configurations.

Therefore, the processing is repeated for different parameter configurations, whereby the configuration for each processing is varied. For the training procedure, the variation of the configuration (and therefore the variation of parameters) may be done by established methods, e. g. gradient descent or backpropagation techniques.

It may be advantageous, in the context of the invention, if the programmable circuit is configured as a programmable integrated circuit, preferably a Digital Signal Processor (DSP), a Complex Programmable Logic Device (CPLD) or a Field Programmable Gate Array (FPGA). Alternatively, the circuit may be configured as a fixed circuit like an application-specific integrated circuit (ASIC) or another integrated circuit. In general, any computer or controller (e.g. PC, microcontroller, DSP, CLPD, FPGA etc.) can be used for machine learning, particularly by the machine learning procedure. The FPGA, in particular, is suitable for high-speed real-time digital signal processing and can accelerate a machine learning procedure. In addition, the usage of a programmable circuit, particularly an FPGA, allows for a flexible and automated training. Many applications of the radio-frequency system like plasma applications evolve in various ways, and an FPGA solution has the advantage that future applications which require adapted processing, e.g., filter designs which are not yet known, can still be handled with the same hardware architecture. In contrast, a fixed circuit, e. g. an ASIC, would need to be modified or even completely redesigned. This would result in more work and cost. The method according to the invention preferably allows to add new configurations simply via a software upgrade which may include more advanced filter configurations. A user can then select one of these configurations for the new application.

Furthermore, according to the present invention the method further comprises:
- Parametrizing the same or another programmable circuit using the at least one determined parameter result,
- Sensing the radio-frequency signal of the radio-frequency system,
- Performing the digital signal processing by using a processing of the sensed radio-frequency signal at least partially by the parametrized circuit,
- Monitoring the radio-frequency signal by repeatedly performing the sensing and the digital signal processing, wherein preferably the processing procedure can be referred to as a training procedure used for performing the parametrization of the programmable circuit in a training mode of the processing using a pre-existing signal as training input signal, and/or wherein the processing procedure can be configured with a parametrization which is retrieved from memory and may have been previously determined in training mode, whereas particularly the monitoring is performed in a real-time mode of the processing, in which the radio-frequency signal is sensed and processed as a real-time input signal.

This means that the radio-frequency system can be actually used practically in real time, and the processing can be switched from the training mode to the real-time mode.

At a later point of time the radio-frequency system may be switched back from real-time mode to training mode, and the parametrization may be further optimized by repeated processing of additional pre-existing signals, e. g. previously recorded or simulated signals.

Particularly, it is an advantage of the invention that the programmable circuit allows for both real-time processing of input signals as well as training of the system by repeatedly processing pre-existing training signals to determine an optimum configuration for the real-time processing mode. The pre-existing signals can be previously recorded signals or e.g. computer simulated signals.

These two functions make the RF system very versatile and allow it to be trained to handle new plasma processing conditions or detect new situations without the need of changes to hardware and algorithm; only the parametrization of the programmable circuit is changed. Instead of having to use external computers for analyzing measured signals and determine an improved configuration, such an optimized configuration can be determined on the actual RF system itself by switching it to the training mode. In this way, the programmable circuit of the RF system has the characteristics of a system capable of machine learning or of an on-device inference framework which both are able to adapt to new applications.

It may be a further advantage of the invention, that the employed programmable circuit, in particular an FPGA, is much faster in performing the digital signal processing, e. g. 10,000 to 100'000 times faster, compared to standard model simulations using standard computers and tools like Matlab/Simulink.

Since the parameter result may comprise an optimized parameter set, i.e. the configuration for each of the at least one parameter that has been optimized using the processing procedure, the programmable circuit may be parameterized using this parameter set of the parameter result. In consequence, the method according to the invention achieves an improved digital signal processing by using a highly accelerated optimization of the at least one parameter in a first step. In a second step of a real-time operation, the processing procedure and the programmable circuit are used, which result in a quicker and smarter choice of the parameter set for the digital signal processing. For the digital signal processing of the sensed radio-frequency signal during the real-time operation, the programmable circuit may receive at least one real-time input signal converted by the analog-to-digital converter from a sensed radio-frequency signal.

Furthermore, the circuit for the optimization of the at least parameter can be the same as for the final application in a real-time operation of the radio-frequency system.

Furthermore, it is conceivable within the scope of the invention that the at least one input signal processed in the processing procedure is configured as at least one training input signal, and the method further comprises:
- Finalizing the parametrization of the programmable circuit by configuring the at least one parameter using the previously determined parameter result, wherein preferably the configuration is subsequently fixed,
- Switching the processing from a training mode to a real-time mode, wherein particularly in the real-time mode a real-time input signal is processed by the programmable circuit in real-time using the fixed configuration, particularly for a filtering of the real-time input signal, wherein preferably the real-time input signal is configured as an actually measured signal received from at least one analog-to-digital converter which converts the radio-frequency signal sensed by at least one sensor to the at least one real-time input signal,
- Switching the processing from the real-time mode to the training mode, wherein preferably in the training mode the existing and previously fixed configuration is further optimized by carrying out the processing procedure again using at least one additional training input signal as the processed training input signal to newly determine the at least one parameter result, wherein, depending on a comparison of the newly determined parameter result with the previously determined parameter result, a re-parametrization of the programmable circuit is performed by configuring the at least one parameter using the newly determined parameter result.

This allows for a further optimization of the existing parameter set. A user may decide if the system should switch to training mode again, to load more reference input signals and reference results for the already existing configuration. The loading or uploading can be carried out via an electronic or user interface. Alternatively or additionally, the additional reference input signals and reference results may be recorded by the RF system itself and directly loaded in real-time operation into the memory for later use in the training mode. Afterwards, the old and new set of parameter configurations are evaluated followed by the storage of the better parameter set into the memory. Additionally, the switching to the training mode from the real-time mode allows a training of new situations at a later point of time: switching to training mode, loading new reference input signals and reference results into the memory, and determining an optimized parameter set, and storing it into a memory.

It is also possible that the user instructs the RF system via the electronic interface if the results of training with new reference input data shall be used to optimize an already existing parameter configuration, i. e. overwriting the already existing configuration with the optimized configuration, or, if the optimized parameter configuration is to be used for a new application and stored as a separate parameter configuration in memory, to be used for the new application, in particular.

According to another embodiment of the inventive method the repeated processing of the at least one input signal is carried out by repeated processing steps, where for each step the same at least one input signal is processed by the same programmable circuit, while using the varied configurations of the at least one parameter, so that the respective processing results are specific for and/or assigned to the varied configurations, and wherein particularly the at least one input signal is provided as one or a plurality of predetermined reference input signals, for each of which a reference result is provided that represents a desired result of the processing of the corresponding input signal, and the determining the at least one parameter result for an optimization of the configuration based on the processing results comprises:
Evaluating the varied configurations by comparing each of the obtained processing results for the at least one reference input signal with the corresponding reference result, wherein preferably the evaluation depends on the matching of the processing result with the reference result, particularly to identify a deviation between the processing result and the reference result. In other words, the parameters can be optimized by varying the configurations. Repeated processing of the same at least one input signal is used, which may apply the different configurations in the sense of different parameter values. This results in - possibly only slightly - different processing results. Each of the processing results can be used to evaluate the performance of the particular configuration that was used to obtain said processing result.

In particular, the references, the reference input signals and/or the reference results mentioned in the context of the invention are also referred to as reference data.

Furthermore, by using the evaluation, an optimization of the configuration can be provided in the sense that the parameter result can comprise a parameter set which leads to processing results with the least deviation from the reference results for all reference input signals. The optimization of the configuration may also be referred to as parameter optimization. The processing procedure may therefore be referred to as a training and/or optimization procedure. The at least one predetermined reference input signal and the corresponding reference results may be referred to as training data. Afterwards, the determined at least one parameter result may be verified by performing the processing and evaluation of the processing results again for a second set of reference data (including new input signals and corresponding reference results). In this way, the issue of overfitting the parameter configuration to the training data is avoided.

It may be provided within the scope of the invention that the determining the at least one parameter result for optimizing the configuration based on the processing results comprises:
- Selecting the at least one configuration with the highest evaluation as the at least one determined parameter result,
- and particularly the providing the at least one determined parameter result for the improved digital signal processing comprises:
- Parametrizing the same or another programmable circuit using the at least one selected configuration,
- wherein preferably said at least one predetermined reference input signal and the corresponding reference results comprise a plurality of predetermined reference input signals and corresponding reference results for different applications of the digital signal processing, so that determining said at least one parameter result for optimizing the configuration based on the processing results is performed separately for each application, and preferably the providing the at least one determined parameter result comprises storing the selected configurations in a memory, wherein the parametrizing the same or another programmable circuit comprises selecting the configuration used from the stored configurations depending on the application.

**In** other words, different training data sets may be provided for different digital signal processing applications. This allows for switching between parameter sets for different applications.

**In** a further possibility, the at least one input signal is configured as multiple pre-existent input signals (also "batch of signals"), wherein preferably the processing procedure comprises repeated processing steps, wherein each processing step comprises:
- Processing the same input signals one after another,
- Setting the configuration of the used at least one parameter in this processing step by a control circuit,
- the method may further comprise:
- Evaluating, after each processing step, a deviation of the processing result from a predetermined reference result by the control circuit,
- Modifying, after each evaluation, the configuration of the used at least one parameter for the next processing step based on said evaluation,
   wherein preferably the control circuit is electrically connected to the programmable circuit and configured separately from the programmable circuit, and
   wherein particularly the configuration of the used at least one parameter is varied for different processing steps to iteratively optimize the configuration for the improved digital signal processing.

The control circuit or control unit may be configured as an additional control processor separate from the programmable circuit which has access to a memory which contains the training data, e. g. the at least one input signals and/or the multiple batches of pre-existent input signals and/or the corresponding reference results. The pre-existent input signals can be previously recorded signals or e.g. simulated signals. The control circuit can also be implemented on the programmable circuit. The programmable circuit can be an FPGA. The providing the at least one input signal, particularly the selection of the training data for the processing procedure (e.g., based on the application that should be trained), and/or the variation of the configurations within the processing procedure may not be done directly by the programmable circuit itself but by the control circuit. For example, for each iteration of the processing, the control circuit may feed the input signals and/or a modified configuration into the programmable circuit. Afterwards, the control circuit may perform the evaluation and therefore decides on the next modification of the configuration depending on the evaluation. It is also possible that the evaluation is at least partly implemented by the programmable circuit to accelerate the training procedure.

Alternatively or additionally, the programmable circuit can have a direct connection to the shared memory, or at least part of the memory may be implemented by the programmable circuit. **In** this case, the control circuit may instruct the programmable circuit from which address range of the memory the training data shall be loaded. Then, the programmable circuit can directly access the memory, load and process the training data one after the other, and evaluate the processing result. This method has the advantage of accelerating the reading from the memory significantly.

It may further be provided in the context of the invention that the processing procedure is configured as a training procedure for the optimization of the configuration in an iterative manner for different specific situations in the application of the radio-frequency system, so that the parameter results determined for the different situations are configured as different optimized parameter sets for these different situations. The different situations can be different applications of the digital signal processing. The different parameter sets can comprise different configurations adapted to these different situations. This allows for a flexible switching between parameter sets depending on the given situation. The training procedure therefore allows a training of different situations which can result in different situationally optimized parameter sets.

In another advantageous embodiment, the at least one input signal comprises a temporal signal course, preferably momentary and historical values, particularly measurement values of the radio-frequency signals or signals derived thereof, and the processing result is obtained by the processing of the signal course to indicate a probability for the detection of a specific pattern in the signal course. Therefore, not only the momentary value of the input signal is considered, but also a series of values from a specific time-interval prior to the latest point is processed and a probability for the detection, i.e., an expected result, may be calculated. In the training mode, the momentary and historical values may be predefined and/or previously recorded. However, in the real-time mode, the real-time input signal may also comprise a temporal signal course, preferably momentary and historical values, and particularly measurement values of the radio-frequency signals or signals derived thereof. In other words, in real-time mode, the processing not only considers the momentary measured value of the radio-frequency signal, but also a series of values from a specific time-interval prior to the latest measurement point. This allows the usage of the processing for different applications, like probabilistic evaluations.

The at least one input signal, i.e., the training input signal and/or the real-time input signal, may be configured as at least one digital signal. The digital signal may be provided by an analog-to-digital converter which converts a sensed analog RF signal into a digital signal. The digital signal can be a digitized representation of the sensed RF signal and therefore may be treated as a 1-dimensional array of datapoints describing the momentary amplitude of the measured RF signal. For consecutive measurements over time, the array can be further extended, so that the latest datapoint(s) represent(s) the latest measurement. The temporal measurement rate of the measurements and therefore of the extension of the array may depend on the sampling rate of the digital-to-analog-converter. By selecting a timeframe of specific length, which is always ending with the latest datapoint, a sequence of 1-dimensional arrays may be obtained which is updated with the measurement rate or the sampling rate of the digital-to-analog converter by shifting older datapoints out from one end, and adding newer datapoints at the other end of the array.

Particularly, in a real-time measurement, there is also a need to identify critical situations and act upon them before they actually evolve into an unwanted event. Such a method is particularly useful in the treatment of overvoltage or overcurrent situations in electrical equipment, or in the management of arc events during a plasma process. In consequence, a continuous analysis of a stream of measured data concerning the presence of specific patterns may be required.

Advantageously, the method according to the invention further comprises a detection of at least one pattern in the sensed radio-frequency signal and/or the at least one input signal. To improve the reliability of detection of a specific situation, radio-frequency signals measured by several sensors can be used in combination such that in each signal at least one pattern is present at a certain point of time. For example, a successful detection of an event may require that in two RF signals specific patterns are detected at the same point of time, or with a certain time delay in between. False positive detections due to measurement artefacts or interferences can such be avoided.

Particularly, the "performing the digital signal processing by using the processing of the sensed radio-frequency signal at least partially by the parametrized circuit" and/or the "performing a processing procedure wherein the at least one input signal is repeatedly processed by the programmable circuit using the at least one configurable parameter of the processing" comprises the detection of the at least one pattern in the sensed radio-frequency signal and/or the at least one input signal, respectively. The sensed radio-frequency signal may be configured as a real-time input signal and thus as a digital signal representation as described above. Accordingly, the at least one input signal is also used within the processing procedure and it may be configured as the training input signal and therefore also as a digital signal representation as described above. In both cases, the processing may be designed to provide the detection of at least one pattern, preferably in the form of a pattern recognition. The configuration therefore may be a configuration for the pattern detection, particularly a configuration of a pattern matching algorithm or a pattern recognition algorithm and/or the weights of individual neurons of a neural network. A pattern matching algorithm or a pattern recognition algorithm can have the advantage of being technically less complex to use than a neural network. A neural network however, can detect patterns in some situations more reliably in noisy or fluctuating signals than a simple pattern matching. A combination of both is also possible. Accordingly, the configurable parameter may be configured as a parameter of the algorithm or the neurons of the neural network. The processing procedure may also be configured as or may comprise or may be part of a machine learning procedure for the machine learning and/or the training of the neural network and the digital signal processing may relate to the application of the trained neural network. The at least one parameter result for an optimization of the configuration can be furthermore configured as the training result in the form of a set of weights for the neurons. It may be provided that an occurrence of an event is detected and/or predicted based on the detection of at least one pattern.

Furthermore, it may be provided that an action is initiated based on the detection or prediction. Particularly, a result of the pattern detection is a probability for the occurrence of the pattern. Additionally, or alternatively, the detection and/or prediction based on the detection comprises a determination of a probability for the occurrence of the event. An initiation of an action may depend on a comparison of this probability with a threshold value. This particularly allows to initiate the action prior to the completion of the event. The action may be a corrective action to counteract the occurrence of the event, such as shutting down the RF system.

**In** a more advanced embodiment, the probabilistic detection or prediction of an event can be based on several conditions. This can be implemented by monitoring the evolution of the probability for the occurrence of the event over a certain period of time. Instead of detecting an event simply by comparing a momentary probability value with a threshold value, additional conditions for a more reliable detection can be, for example:
- Probability value consistently above a specified threshold value for a specified time period;
- Average probability value above a specified threshold value for a specified time period;
- Increasing probability value after the probability value has exceeded a specified threshold value;
- Derivative of the probability value within a specified time period above a threshold value;
- Correlation of probability values determined for several monitored signals;
- Any combination of one or more of the above and further conditions.

With the help of more complex conditions, the detection of an event can be made more reliable and less dependent on momentary fluctuations of the probability value. Advantageously, the monitoring period for the probability value can be chosen sufficiently short so that the event can still be inhibited prior to its completion by initiating an action. The training of the system can therefore comprise a parametrization with regard to a detection of an event as early as possible and/or a classification of an event as precise as possible. Said results can then be higher weighted in the parametrization.

It may be provided that in the at least one digital signal, particularly in the form of such line arrays as described above, specific patterns can be detected. Preferably, the detection of a pattern is trained using the training input signal as the digital signal and/or performed in real-time using the real-time input signal as the digital signal. The latter allows the identification of events during the operation of the RF system based on the detection of the pattern. The events may relate to problems that occur in the RF system or in the plasma processing system that require an action such as shutting down the RF system. Moreover, the events may also indicate degradation of specific components of the RF system or the plasma processing system. The event can be reported, e. g. by notifying the user via a specific analog or digital signal which can be provided via an electronic or user interface, such that the user can react to the situation with additional corrective actions, or repair and/or preventive maintenance can be scheduled for at a later point of time.

The specific pattern may comprise interferences as described above and/or irregularities and/or characteristic changes. These patterns may be connected to certain phenomena in the plasma process, the plasma processing system, or in the RF power delivery system. If the RF signal is repeatedly sensed by successive measurements, then the digital signal represents the successively sensed signal. It may be possible that, by consecutively processing the digital signal, particularly the resulting sequence of the 1-dimensional arrays, the evolution of certain patterns with time can be monitored.

Furthermore, by using an artificial neural network, the detection of fully evolved specific patterns may be learned by optimizing the weights of the individual neurons, and with the optimized set of weights the network can then recognize the occurrence of a particular pattern in real-time. In order to detect an event before it is fully completed, an appropriate output function for the neural network may be chosen which produces a probability for a specific pattern in the real-time input signal or data stream.

The same result may be achieved by calculating the cross-correlation between a reference pattern and a stream of actually measured signal data. The reference pattern is continuously shifted in time with respect to the signal waveform.

If the event has fully evolved, the pattern would be recognized with a probability of close to 1. However, prior to that point in time, the calculated probability already gradually increases from 0 towards 1. As soon as the probability exceeds a certain user-adjustable threshold or a combination of several conditions as described above, the event can be reported before its actual completion. In this way, irregularities in the stream of measured data which are correlated with unwanted or even disastrous events, can be flagged before the consequences of the event occurrence. In this case, countermeasures can be initiated to avoid the full evolvement of the event and reduce and/or suppress severe consequences. The probability threshold value and further conditions as described above can be individually set for each type of event. For example, disastrous events can be handled with a low threshold while small irregularities can have a higher threshold. The advantage of using a lower threshold for severe irregularities is a longer time period for performing corrective action before the event has fully evolved. On the other hand, higher thresholds allow to classify an event with higher accuracy.

For example, arcing above the surface of a semiconductor wafer in a plasma processing system can cause severe defects and loss of one or more chips on the wafer. If an arc is strong enough, the plasma processing sequence might be strongly disturbed resulting in the entire wafer to be discarded. For such catastrophic arc events, a low probability threshold is therefore advantageous so that the event can be suppressed in an early stage. In another example, a high probability threshold can be more adequate for less critical events: in plasma processing chambers which are used for deposition processes, not only the semiconductor wafer, but also parts of the plasma chamber are coated with the deposited layer. After processing many wafers, these chamber parts are covered with an increasingly thick layer of deposited material from which particles can fall off. During the plasma process, such particles can cause plasma irregularities which can be tolerated to a certain extent. Nevertheless, it is important to accurately classify and count all particle related events so that preventive maintenance, in this case a cleaning of the plasma chamber, can be initiated if the number of particle-related events exceeds a threshold. In this case, a high probability threshold allows to separate particle-related events from other irregularities, and thus too early cleaning of the chamber caused by counting of false particle events can be avoided.

The implementation of an optimized neural network into a programmable logic device, e. g. an FPGA, may be straightforward, as all parts of a neural network may be transferred into corresponding logic components. In the same way, pattern matching algorithms can be easily implemented into FPGAs by using shift registers and simple logic operations. A change to the configuration and/or the size of a neural network, or a modification of a pattern matching algorithm can be done by loading a new configuration into the FPGA without any change to the hardware.

If the application requires detection of several pattern classes, several parallel neural networks or pattern matching algorithms which are optimized for each specific class can be set up. It is also possible to use one common neural network or pattern matching algorithm to detect multiple pattern classes. In this case, instead of one probability value as output of the network, an array of probabilities, one for each class, is generated. Further pattern class detection can be added later. If required, the parametrization of the neural network or the pattern matching algorithm can be optimized by additional teaching.

Different configurations hereby can be saved for different applications and then activated according to the situation. In particular, it is possible to switch quickly between different configurations, which can be activated one after the other, e.g., for different, successive process steps. Subsequently, further optimization of an existing configuration or learning of new situations with additional reference data may be possible by activating a teaching mode on the installed system. Therefore, probabilistic pattern recognition in the measured signals, even before a pattern is fully developed, by applying parallel (simultaneous) classification into several pattern types, is also possible.

It may further be possible that an electronic interface is provided to upload the at least one input signal or a pre-existent configuration into the inventive system, particularly to the programmable circuit, or into the control unit or into the memory. The inventive method then further parametrizes the programmable circuit using the pre-existent configuration, which is uploaded. If the input signal is uploaded into the control unit, the control unit can load the signal into the memory before feeding it to the programmable circuit. The at least one input signal can be configured as a plurality of input signals, which are stored in a memory after uploading.

The electronic interface may be configured as a user interface, which permits a user to upload the at least one input signal and/or a user input signal and/or a user configuration and/or a control signal to switch the system from training mode to real-time mode and/or a signal to use a specific configuration stored in memory for parametrization of the programmable circuit. Uploaded input signals, which are, generally formulated, training data, may be fed into the programmable circuit for signal processing, either directly or via the control unit, or they are stored into the memory, either directly or via the control unit. The user input signal refers to the at least one input signal from the user. The user configuration can be a pre-existent configuration which the user loads into the interface via e.g. a Cloud or on-site storage. The user configuration can also be a configuration which was created by using the inventive method for the user input signal. **In** general, the training data may comprise the at least one input signal and a corresponding reference result for each input signal. The training data may be configured as pre-existing (previously recorded or simulated) data especially for the training procedure, which can be first loaded into the memory and then processed one by one (in various iterations) until an optimized parameter set is found. The uploaded pre-existent configuration can be stored in the same memory and/or in a different memory and/or the uploaded pre-existent configuration can overwrite the configuration already implemented according to any inventive method described above. When the uploaded pre-existent configuration is stored in the same memory, it can act as supplementary/additional parametrization of the programmable circuit. The advantage of the uploaded configuration stored in a different memory, or memory space, is that a back-up configuration is always at hand. It can also be an advantage for the manufacturer to limit the accessibility of any configuration that was not performed by the user. **In** this case it is also an option to load either of the configuration into a secure and trusted memory space. The advantage of overwriting the configuration of the programmable circuit by uploading other configuration is a new parametrizing of the programmable circuit and less memory space that are needed.

It is possible that an electronic interface is provided to access, particular read out and/or write and/or overwrite, the parameter configuration and/or the fixed configuration and/or the at least one input signal and/or data from the memory and/or from the programmable circuit and/or from the control unit. However, it can also be possible that the access via the electronic interface is restricted, e.g. in such a way that the reading out and/or overwriting and/or exchanging of certain data and/or of the algorithm or neural network is prohibited. Therefore, a part of the data or information stored in the memory and/or the programmable circuit and/or the control unit can be locked, e.g. by using cryptographic methods. **In** other words, it is possible that the electronic interface can be used to carry out an upload of configurations which are to be stored in memory for use in specific applications. These configurations can be the result of a training procedure which is performed on a similar circuit with appropriate training data. **In** particular, the manufacturer can allow the upload of configurations to the user, but at the same time, a basic, factory configuration as well as the algorithm or the neural network itself, can be protected from access by the user. This has the advantage, that the user can still go back to the factory configuration if he is not satisfied or if the system is no longer operational with the new configuration.

It is possible to perform the training and the determination of an optimum set of parameters for the parametrization of the circuit by using only the programmable circuit, the user interface, memory and the control as a training bench. As in the training mode of the full radio-frequency system, training data which are already digitized are read from memory and provided by the control as input signal(s) for the digital signal processing. The variation of the parameters and the evaluation of the result of the processing are also performed in an identical way as in the full RF system. This training bench system with a typical, commercially available FPGA is able to determine an optimized parameter result in much shorter time, e. g. 10,000 to 100,000 times faster, compared to standard model simulations using standard computers and tools like Matlab/Simulink.

An optimum parametrization of a typical filtering algorithm as used in radio frequency systems can be determined with the described training bench system within minutes, compared to runtimes of hours or days when Matlab/Simulink simulations are used.

Even for large neural networks with several thousand neurons arranged in, for example, 500 to 1000 layers, the training bench system is able to determine an optimum set of neuron parameters within several hours. For even more complex algorithms or neural networks and/or for very large sets of training input data, the determining of an optimum configuration of the programmable circuit can be performed on a dedicated high-performance supercomputer.

Independent from the above described possibilities of determining an optimum configuration - on the RF system itself, on a training bench system, on a standard computer using simulation tools, or on a high-performance supercomputer, the determined configuration can be uploaded by the control to the memory of the RF system via a user interface, and then, for specific applications, be used for parametrizing the programmable circuit which is then able to process input signals of the RF system in real time.

In the same way, configurations determined with one RF system, can be exported via the user interface, and uploaded to similar RF systems to be used for parametrization of the programmable circuit. In this way, by implementing an existing configuration from a first RF system onto a second system of the same kind, the individual training of the second system can be avoided. Therefore, a copy of an already optimized configuration can be used on multiple systems which has the advantage of saving time when setting up a new system.

Depending on unavoidable small variations from system to system, it might be required to further optimize the parametrization of a new RF system. Nevertheless, this optimization of parameters will typically converge must faster when starting from an already known good configuration compared to starting from a default parameter configuration which might be the case for completely new applications.

The at least one input signal may be configured as a predefined reference input signal for each of which a desired result of the processing is provided as a corresponding predefined reference result. The training data may comprise the predefined reference input signal and the corresponding predefined reference result as well.

It may be possible that the circuit executes an algorithm that is parametrized by the at least one configurable parameter of the circuit for providing the processing of the at least one input signal. The interface, particularly user interface, may be used for a selection of an appropriate configuration for the parameter before the process is started. Alternatively, or additionally, the interface may be used for a switching from an application or real-time operation mode to a training mode. The processing procedure may be configured as a learning cycle for the optimization of the configuration. It may also be possible that a user controls the interface to load reference input signals and/or reference results and/or training data into a memory, particularly a memory of the radio-frequency generator, and/or to run the learning cycle and/or to store a new parameter configuration in the memory for later use in application mode. **In** the training mode, the memory may be used to simulate the continuous data stream from the analog-digital-converter from the application mode. Therefore, the memory may be connected to the control circuit, and the control circuit can read the at least one input signal from the memory and provide it to the programmable circuit in the training mode. It is also possible that the programmable circuit may read the at least one input signal directly from memory and perform the signal processing in order to accelerate the processing. On the other hand, in the application or real-time operation mode the programmable circuit can be directly connected to the analog-digital-converter to receive the input signal as a real-time input.

It is a further option that the at least one input signal is configured as at least one thousand or at least one million different input signals, wherein each of the input signals represents at least one waveform related to the radio-frequency signal, wherein the processing is intended to evaluate the waveform depending on the parameter configuration, whereby the respective processing results comprise a result of said evaluation. This allows a further increase of performance of the processing. Furthermore, the automated training, e. g., controlled by the control circuit, can accelerate the optimization of the at least one parameter.

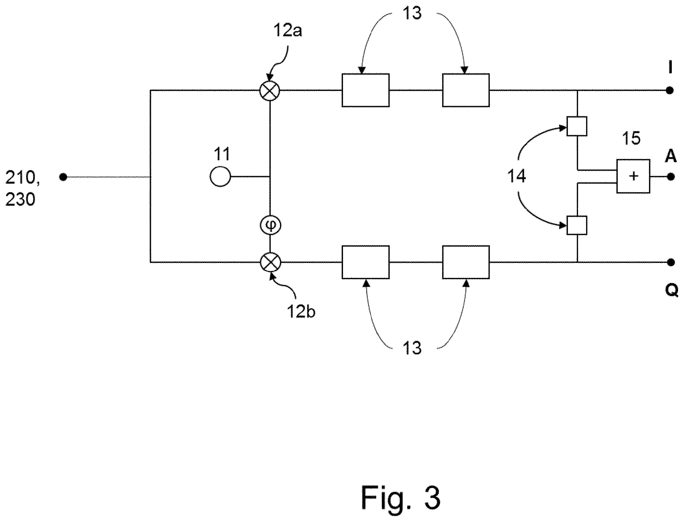

In another advantageous embodiment the programmable circuit comprises logic elements for decomposing the input signal into amplitude and phase using an algorithm, wherein the algorithm is parametrized by the varied configurations. The algorithm, such as an IQ demodulation or Goertzel-algorithm or Discrete Fourier Transformation, therefore, relies on a number of parameters. For example, in the case of the IQ demodulation, the parameters can be the coefficients of digital filters. The configuration of the parameters is therefore the concrete value chosen for these parameters. Further details can be found in the description of fig. 3 below.

Furthermore, it is conceivable that an evaluation of the varied configurations is carried out by comparing each of the processing results associated with the varied configurations with a predetermined reference result, wherein the predetermined reference result comprises a predetermined ideal result of an algorithm that is carried out by the programmable circuit. The predetermined ideal result is therefore a reference for quality of the currently set configuration. The variation of the parameter configuration allows to produce different processing results which can be compared to the reference result. The deviation between the processing results to the reference results shows the performance of the used configurations, which may be understood as the evaluation of the configurations.

Another aspect of the invention is a system, particularly an RF measurement system for a radio-frequency system, preferably a radio-frequency power delivery system or a radio-frequency generator or a radio-frequency plasma system, comprising:
- at least one sensor, particularly a directional coupler or a voltage-current ("V/I") sensor, for sensing a radio-frequency signal of the radio-frequency system,
- at least one analog-to-digital converter for converting the at least one sensed radio-frequency signal into an at least one input signal,
- a circuit, particularly a programmable circuit, for a digital signal processing of the at least one input signal. It can be provided that the circuit is parameterized by the at least one parameter result determined according to a method according to the invention.

Thus, the system according to the invention system brings the same advantages as have been described in detail with reference to the method according to the invention. The system may also comprise an analog anti-aliasing filter and/or a matching circuit. The radio-frequency system can particularly be configured as a radio-frequency power delivery system. The radio-frequency power delivery system may further be configured as a power supply of a plasma system, particularly a plasma power delivery system. An analog-to-digital converter may be provided to convert a sensed radio-frequency signal used for the power supply and sensed by a sensor of the radio-frequency system.

The system can further comprise an electronic interface for uploading a pre-existent configuration into the programmable circuit or into the control unit or into the memory for the parameterizing of the circuit. The upload and/or a writing and/or a reading using the interface can be performed using a data transfer. The electronic interface may be electronically connected with the control unit or the memory or the programmable circuit for performing the uploading using the (particularly direct) data transfer. The electronic interface can be configured as a data interface like a serial interface that can be connected with another electronic device like a computer. It is also possible that the electronic interface executes a computer program to allow the data transfer. The computer program may provide a more sophisticated interface technology like a local area network, a wireless local area network or Bluetooth. The electronic interface can be accessible via the control unit or the memory or the programmable circuit.

The system according to the invention can feature any of the above-mentioned features of the method according to the invention to further exhibit the described advantageous characteristics.

Further advantages, features and details of the invention will be apparent from the following description, in which embodiments of the invention are described in detail with reference to the drawings. In this connection, the features mentioned in the claims and in the description may each be essential to the invention individually or in any combination.

### Short description of the figures

- Fig. 1a: shows an embodiment of an inventive RF measurement system 1 and an data carrier signal.
- Fig. 1b: shows an embodiment of a plasma power system employing the inventive RF measurement system 1.
- Fig. 2: shows an embodiment of an inventive method for improving DSP in an inventive radio frequency system.
- Fig. 3: shows the principle of operation in an inventive programmable circuit used for the DSP.
- Fig. 4: shows an embodiment of the inventive RF measurement system in training mode configuration.
- Fig. 5: shows an embodiment of the inventive RF measurement system in application (real-time operation) mode.

### Detailed description of the figures

In the following figures, the identical reference signs are used for the same technical features even of different embodiment examples.

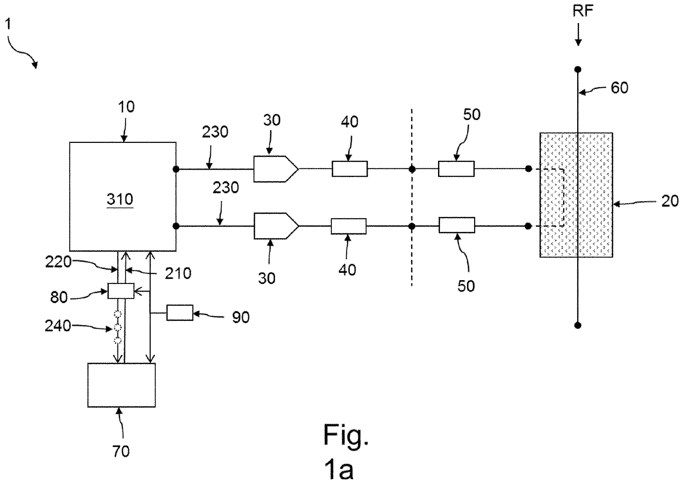

Fig. 1a shows an embodiment of an inventive RF measurement system 1 of a radio-frequency generator, preferably a radio-frequency power delivery system 1 or a radio-frequency generator or a radio-frequency plasma system. The system comprises at least one sensor 20, particularly a directional coupler or a voltage-current sensor or a plasma sensor 32, for sensing a radio-frequency signal of the radio-frequency systems 1. The directional coupler 20 is a type of sensor commonly used to probe radio-frequency signals in e.g., power delivery circuits. Other sensors, however, can be implemented also. Fig. 1a further shows a radio-frequency RF power signal transmission line 60 and two signal branches, where the top branch can be representative of the forward power and the bottom branch representative of the reflective power of the RF power signal picked-up by the sensor 20. The structures of the inventive system 1 described herein can be suitable for either the measured forward power or the reflected power or both. The structures of the inventive system 1 described herein can also be suitable for an RF voltage, an RF current, a reflection coefficient (Γ or "Gamma value") or a measured DC-Bias or any combination of the RF Phase with AC current (measured forward or reflected power or both) and the DC Bias and the reflection coefficient.

The system 1 further comprises at least one analog-to-digital converter, an ADC, 30 for converting the at least one sensed radio-frequency signal to an at least one input signal 230. The ADC transforms a time-continuous and value-continuous, aka analog, signal into a time-discrete and value-discrete, aka digital, signal. The analog signal can be the one picked up by a directional coupler 20. The number of samples per second is given by the sampling rate and the number of different values is given by the number of bits of the ADC 30. The system 1 can further comprise an analog anti-aliasing filter 50 and a matching circuitry 40 between the sensor and the ADC 30.

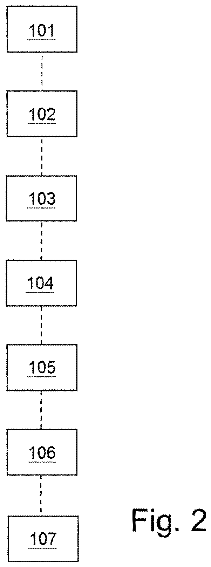

The system 1 comprises for the digital signal processing a, preferably programmable, circuit 10. The circuit 10 is suitable for a digital signal processing of the at least one input signal 230. The input signal 230 can be a measured signal during operation of the RF-generator, aka real-time mode signal 230. The circuit is further suitable for a digital signal processing of an at least one input signal 210 stored in a memory 70. Either the input signal 230 or the stored input signal 210 can be signals related to a radio-frequency signal of the power delivery system. They can therefore be directly measured signals or simulated signals. The stored input signal 210 can be further processed by a controller or control circuit 80 before going into the circuit 10. The circuit 10 can further be parameterized by the at least one parameter result determined according to an inventive method described in fig. 2. The parametrization can happen before any input signal 210 or 230 has reached the circuit 10. The parametrized circuit 10 then gives out a processing result 220 in accordance with an input signal (either from memory 210 or from real-time mode 230). The processing result 220 then passes by the control circuit 80 and can be stored into the memory 70 as a parameter result 240.

Fig. 1a also shows a data carrier signal 240, carrying the at least one parameter result 240 determined from the processing result 220. The data carrier signal 240 can be a data package, available for download by authorized persons or any third party. The data carrier signal can then be used to parametrize the programmable circuit 10, especially an FPGA 10. The processing result 220 used for the parameter result 240 can be determined from an inventive method according to at least one of the methods described herein. The system can further comprise an electronic interface 90 for uploading a pre-existent configuration into the programmable circuit 10 or into the control unit 80 or into the memory 70 for the parameterizing of the circuit 10. Said electronic interface 90 can be electronically connected with the control unit 80 or the memory 70 or the programmable circuit 10 for performing the uploading using a direct data transfer. Additionally, the electronic interface 90 can also be used for performing a downloading of a configuration, for example for transferring it to a different RF system for a similar application. The electronic interface 90 can be a user interface.

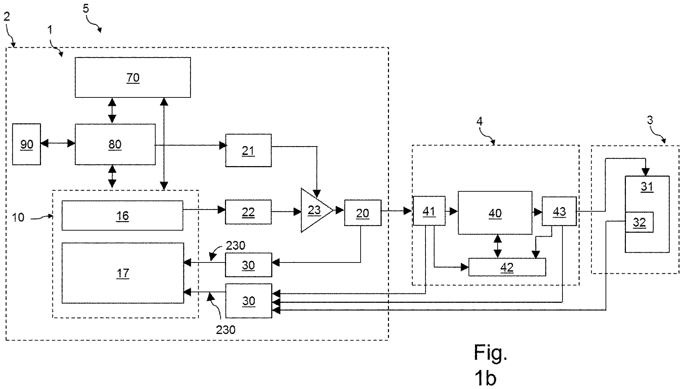

Fig. 1b shows an embodiment of a plasma power system 5 employing the inventive RF measurement system 1. In particular, the plasma power system 5 comprises an RF generator 2, a matching network 4, and a plasma process system 3, e. g. a plasma chamber 31 with electrodes to which RF power is provided.

The RF generator 2 comprises the RF measurement system 1 comprising a sensor 20, analog-to-digital converters 30, a programmable circuit 10, a control unit 80, a memory 70 and an electronic interface 90 also referred to as user interface 90. Additionally, the RF generator 2 comprises a signal generation unit 16, e. g. a direct digital synthesis (DDS) circuit and a power amplifying stage 23 to which power is provided from a DC supply 21, wherein the signal generation unit 16 can be implemented in the programmable circuit 10. It is to be noted, that within the scope of this invention, the signal generation unit 16 may also be a separate circuit or chip, external to the programmable circuit 10.

The matching network 4 comprises an input sensor 41, e. g. a phase and magnitude detector, an impedance matching circuit 40, typically comprising inductors and capacitors which can be variable, a match control unit 42, and, optionally, an output sensor 43, e. g. a voltage-current sensor or a DC bias sensor. The function of the matching network 4 is to adapt the output impedance of the RF generator 2, typically 50 Ohms, to the variable impedance of the plasma process system 3 such that the RF power coupled into the plasma is maximized and power reflected back from the plasma process system 3 is minimized.

The plasma process system 3 comprises a plasma chamber 31 to which the RF power from the matching network 4 is provided. Within the plasma chamber 31, a gas or a gas mixture is excited and partially ionized by the RF power which is fed in. The electrical coupling of the RF power into the plasma can be achieved by connecting the RF power to an electrode, e. g. a metal plate which is opposite to a similar plate connected to ground. In this way, the plasma is capacitively coupled to the two electrodes. Alternatively, the RF power can be connected to an inductor which is arranged around the plasma chamber 31 such the plasma is coupled inductively.

Typically, semiconductor wafers are loaded into the plasma chamber 31 and exposed to the RF plasma for a specified time to obtain etching of material from the topmost layer of the wafer or deposition of material to the topmost layer of the wafer.

The matching network 4 and the plasma process system 3 can comprise sensors 41, 43, 32 which measure signals which are characteristic for properties of the RF signal or the plasma process. Such sensor signals can be connected to dedicated sensor ports of the RF generator 2, converted to digital representations by means of analog-to-digital converters (ADCs) 30, e. g. single- and/or multi-channel ADCs, and can be used as input signals for the digital signal processing performed by the programmable circuit 10.

Fig. 2 shows an embodiment of an inventive method for improving DSP in an inventive radio frequency system, in particular a radio-frequency power delivery system 1. The method comprises a providing 101 of at least one input signal 210 related to a radio-frequency signal of the radio-frequency system 1, and a performing 102 of a processing procedure 310 wherein the at least one input signal 210 is repeatedly processed by a programmable circuit 10 using at least one configurable parameter of the processing. The configuration hereby of the at least one parameter can be varied or particularly modified for each processing of the at least one input signal 210 to obtain respective processing results 220. The method further comprises a determining 103 of at least one parameter result for an optimization of the configuration (e.g., the optimized parameter, particularly from the varied parameters) based on the processing results 220, as well as a providing 104 of the at least one determined parameter result for the improved digital signal processing (particularly for the parametrization of the circuit). For the inventive method, the programmable circuit 10 can be configured as a programmable integrated circuit 10, preferably an FPGA.

The inventive method can further comprise a parametrizing 105 of the same or another programmable circuit 10 using the at least one determined parameter result, wherein the parametrizing 105 comprises a sensing 106 of the radio-frequency signal of the radio-frequency system 1, and a performing 107 of the digital signal processing by using a processing of the sensed radio-frequency signal at least partially by the parametrized circuit 10. The inventive method can further comprise a monitoring of the radio-frequency signal by repeatedly performing 102 the sensing 106 and the digital signal processing. Irrespective of the details of the parametrizing 105 of the circuit 10, the processing procedure 310 of the programmable circuit 10 can be configured as a training procedure for performing the parameterization 105 of the programmable circuit 10 in a training mode of the processing using the input signal 210 as a pre-existing (e.g. previously recorded or simulated) training input signal 210, whereas the monitoring is performed in a real-time mode of the processing, in which the radio-frequency signal is sensed and processed as a real-time input signal 230.

The at least one input signal 210 processed in the processing procedure 310 can be configured as at least one training input signal 210. The inventive method can further comprise a finalizing of the parametrization 105 of the programmable circuit 10 by configuring the at least one parameter using the previously determined parameter result, wherein the configuration is subsequently fixed; and a switching of the processing from a training mode to a real-time mode, wherein in the real-time mode a real-time input signal 230 is processed by the programmable circuit 10 in real-time using the fixed configuration, particularly for a filtering of the real-time input signal 230, wherein preferably the real-time input signal is configured as an actually measured signal received from at least one analog-to-digital converter 30 which converts the radio-frequency signal sensed by at least one sensor 20 to the at least one real-time input signal; and a switching the processing from the real-time mode to the training mode. In the training mode the existing and previously fixed configuration can be further optimized by carrying out the processing procedure 310 again using at least one additional training input signal 210 as the processed training input signal 210 to newly determine the at least one parameter result, wherein, depending on a comparison of the newly determined parameter result with the previously determined parameter result, a re-parametrization of the programmable circuit 10 is performed by configuring the at least one parameter using the newly determined parameter result.

The repeated processing of the at least one input signal 210 can be carried out by repeated processing steps, where for each step the same at least one input signal 210 is processed by the same programmable circuit 10, while using the varied configurations of the at least one parameter, so that the respective processing results 220 are specific for and/or assigned to the varied configurations. The at least one input signal 210 can be configured as one or a plurality of predetermined reference input signals 257, for each of which a reference result is provided that represents a desired result of the processing of the corresponding input signal 210. The determining 103 of the at least one parameter result for an optimization of the configuration based on the processing results 220 can further comprise an evaluating of the varied configurations by comparing each of the obtained processing results 220 for the at least one reference input signal 257 with the corresponding reference result, wherein the evaluation depends on the matching of the processing result 220 with the reference result or the deviation between processing result 220 and reference result. The determining 103 of the at least one parameter result for optimizing the configuration based on the processing results 220 can further comprise a selecting of the at least one configuration with the highest evaluation as the at least one determined parameter result. It is possible that the reference result is provided by a user, e.g. uploaded using a user interface 90. Therefore, a user can define at any time what criteria are used for the evaluation. It is also possible that the input signals and therefore the training data is defined by the user, and e.g. uploaded via the user interface 90 for that reason. The providing 104 of the at least one determined parameter result for the improved digital signal processing can further comprise a parametrizing 105 of the same or another programmable circuit 10 using the at least one selected configuration. Preferably, said at least one predetermined reference input signal 257 and the corresponding reference results comprise a plurality of predetermined reference input signals 257 and corresponding reference results for different applications of the digital signal processing, so that determining said at least one parameter result for optimizing the configuration based on the processing results 220 is performed separately for each application. The providing 104 of the at least one determined parameter result can further comprise storing the selected configurations in a memory, wherein the parametrizing the same or another programmable circuit 10 comprises selecting the configuration used from the stored configurations depending on the application.

The at least one input signal 210 can be configured as multiple pre-existent input signals 210. The pre-existent signals can be previously recorded or e.g. simulated. The processing procedure 310 can comprise repeated processing steps, wherein each processing step can comprise a processing of the same input signals 210 one after another, and a setting of the configuration of the used at least one parameter in this processing step by a control circuit 80. The inventive method can further comprise an evaluating, after each processing step, of a deviation of the processing result 220 from a predetermined reference result by the control circuit 80, and a modifying, after each evaluation, of the configuration of the used at least one parameter for the next processing step based on said evaluation. The control circuit 80 can hereby be electrically connected to the programmable circuit 10 and configured separately from the programmable circuit.

The configuration of the used at least one parameter can vary for different processing steps to iteratively optimize the configuration for the improved digital signal processing.

The processing procedure 310 can be configured as a training procedure for the optimization of the configuration in an iterative manner for different specific situations in the application of the radio-frequency system 1, so that the parameter results determined for the different situations are configured as different optimized parameter sets for these different situations.

The at least one input signal 210 can comprise a temporal signal course, preferably from momentary and historical values, particularly from measurement values of the radio-frequency signals. The processing result 220 can be obtained by the processing of the signal course to indicate a probability for the detection of a specific pattern in the signal course.

An electronic interface 90 can be further provided to carry out an upload of the at least one input signal 210 to the programmable circuit 10. The at least one input signal 210 hereby can be configured as a plurality of input signals 210, which are stored in a memory after uploading.

The at least one input signal 210 can be configured as at least one thousand or at least one million different input signals 210, wherein each of the input signals represents at least one waveform related to the radio-frequency signal. The processing hereby can be intended to evaluate the waveform depending on the parameter configuration. The respective processing results 220 can comprise a result of said evaluation.

A pre-existent configuration can also be uploaded via an electronic interface 90, particularly into the programmable circuit 10 or into the control unit 80 or into the memory 70. The parametrizing of the programmable circuit 10 then uses the pre-existent configuration. The uploaded pre-existent configuration can be stored in the same memory 80 and/or in a different memory. The uploaded pre-existent configuration can either overwrite any of the configurations that were calculated using the inventive method or it can be stored in memory in addition to any other configurations that were calculated using the inventive method or uploaded and stored in memory previously.

The programmable circuit 10 can comprise logic elements for decomposing the input signal 210 into in-phase and quadrature component (I/Q demodulation) or into amplitude and phase using an algorithm, wherein the algorithm can be parametrized by the varied configurations.

An evaluation of the varied configurations can be carried out by comparing each of the processing results 220 associated with the varied configurations with a predetermined reference result. The predetermined reference result can comprise a predetermined ideal result of an algorithm that is carried out by the programmable circuit 10.

Fig. 3 shows a dataflow graph of an IQ demodulator that can be implemented in an FPGA as a programmable circuit 10 according to the invention. The FPGA provides logic elements that allow mathematical operations to be performed on the digital input signals 210, 230. By arranging the logic elements of the FPGA, the digital signals 210, 230 can be decomposed into amplitude and phase. The decomposition can be performed via different algorithms, such as IQ-demodulation, Goertzel algorithm or Discrete Fourier Transformation (DFT), etc. The example shown in fig. 3 illustrates a decomposition of a digital input signal 210, 230 with IQ-demodulation which results in an in-phase portion of the signal becoming available at point I and an out-of-phase (or quadrature) signal becoming available at point Q. Elementary operations can be the square 14 and the sum 15 of the digital signals to reconstruct the amplitude of the original signal 210, 230 and provide it at point A. Here, the sum of the square value of the in-phase signal and the squared value of the out-of-phase signal is equal to the squared value of the amplitude. The FPGA 10 further comprises a local oscillator 11 which provides an internally generated digital signal at a given frequency and phase. For example, the local oscillator 11 can provide values for the function f(t) = sin(ω₁t). Since the FPGA is programmable, any frequency ω₁ between 0 and the half of the sample-frequency can be generated by the local oscillator 11 in accordance with the Nyquist theorem. The frequency can also be swept from one value to another value during consecutive time intervals. For the I-demodulation, the FPGA then performs a multiplication 12a of the internally generated digital signal from the local oscillator 11 and the input digital signal 210 or 230. For the Q-demodulation, the FPGA performs a multiplication 12b of the digital input signal 210 or 230 with the internally generated digital signal from the local oscillator 11 with an offset Φ = 90°. This offset ensures that if the multiplication 12a for the I-demodulation is done with a sine function, then the multiplication 12b for the Q-demodulation is done with the corresponding cosine function. The generated values obtained by multiplications 12a, 12b are then processed with digital filters 13. The filters can have adjustable parameters for example in order to adjust the slope of the filters acting beyond a cut-off frequency. Any of the decomposition algorithms rely on a number of parameters. In case of the IQ-demodulation, the coefficients of the digital filters are those mentioned above. The operations performed on a digital signal to extract information can reveal the mean value over time, standard deviations or various other statistical information depending on the desired outcomes of the digital signal processing. The algorithm and parameters can further be simulated on a computer using generic programming languages such as Python or specific tools such as Xilinx Add-on System Generator for Matlab-Simulink. The computation time on standard computers exceeds the duration of the simulated time by many orders of magnitude; therefore, the aforementioned inventive method which uses a programmable circuit, in particular an FPGA, can shorten the duration of execution of the simulation greatly.

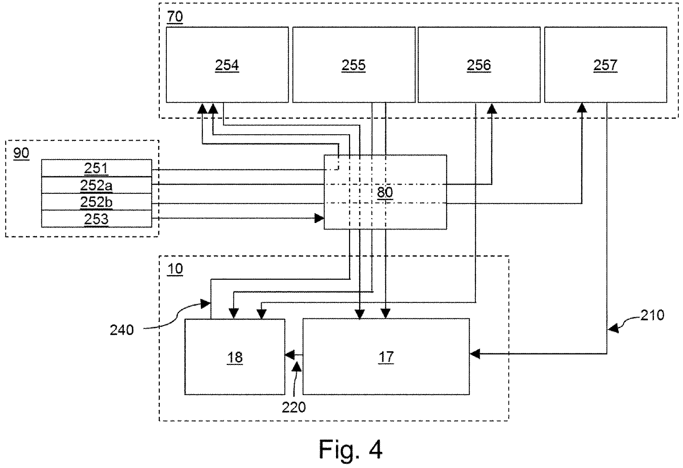

Fig. 4 shows an embodiment of the inventive RF measurement system 1 set up for operation in training mode, e. g. as a training bench system. The operation mode 253 of the system 1 can be set to training mode via the user interface 90.

In the following, the term "signal processing circuit", referred to by reference sign 17, designates a part of the programmable circuit 10 which is dedicated to performing the signal processing. The programmable circuit 10 can comprise further circuits, e. g. an evaluation circuit 18 which is used in training mode for determining the deviation between a processing result 220 and a reference result. Further circuits which are used during real-time mode may be implemented in the programmable circuit 10 but may be deactivated in training mode.

When in training mode, the connection of the system 1 to a power amplifying stage 23, an impedance matching network 4, and a plasma process system 3 are not mandatory. Instead of real-time input signals provided by sensors within the RF generator 2, the matching network 4, or the plasma process system 3, the system 1 may process pre-existent reference input signals 257 which are stored in the memory 70 or uploaded via the user interface 90. Additionally, reference results 256 can be stored in the memory 70 or provided via the user interface 90. These reference results indicate the expected result of the signal processing of the reference input signals 257. Also, parameter configurations 254, which can be used to parametrize the signal processing circuit 17 can be stored in the memory 70 or provided via the user interface 90.

Moreover, also algorithms for digital signal processing or circuit layouts 255, e. g. of a neural network, which can be implemented into the programmable circuit 10 can be stored in the memory 70. Typically, the upload of algorithms and circuit layouts 255 via the user interface 90, and their implementation into the programmable circuit 10 are restricted for the manufacturer, and not accessible to regular users of the system 1.

**In** training mode, the control 80 can be set up to read user parameter sets 251, user reference results 252a, and user reference input signals 252b from the user interface 90, and store them into the memory 70. Additionally, the control 80 can be set up to parametrize the programmable circuit 10 by reading a stored parameter set 254 from the memory 70 and parametrizing the programmable circuit 10 accordingly.

Furthermore, the control 80 can be set up to read reference input signals 257 from the memory 70 or from the user interface 90 and provide them as input signals 210 to the signal processing circuit 17. Alternatively, the signal processing circuit 17 may access the memory 70 directly and read parameter configurations 254 and training data, i. e. reference input signals 257 and reference results 256 directly such that the reading and processing of the training data is accelerated.

Furthermore, the evaluation circuit 18 as shown in Fig. 4 can be implemented in the programmable circuit 10 or, alternatively, as a software algorithm in the control unit 80. The result of the evaluation, i. e. an optimized parameter set 254 may be stored in the memory 70, either by retrieving it from the programmable circuit 10 and writing it to the memory 70 via the control 80, or by direct memory access from the programmable circuit 10.

**In** addition, it is to be noted that, as an alternative to the arrangement of Fig. 4, at least part of the control unit 80 and/or at least part of the memory 70 can be implemented in the programmable circuit 10. This has the advantage that the reading of reference input signals 257 and reference results 256 from the memory 70 and the subsequent signal processing of the reference input signals 257 and the evaluation of the processing results 220 with respect to the reference results 256 can be accelerated considerably.

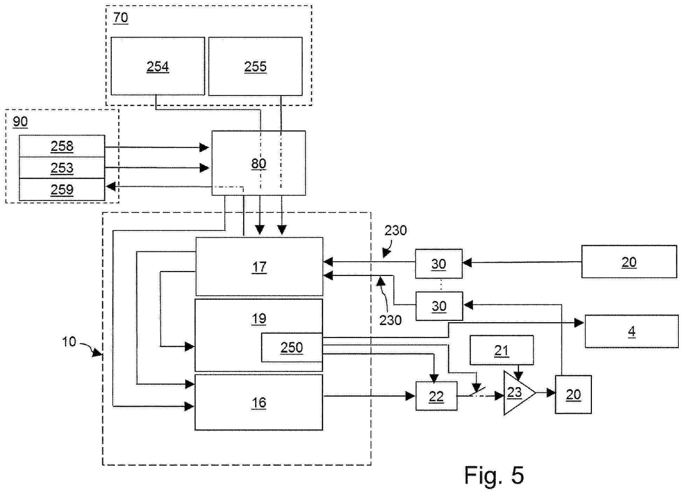

Fig. 5 shows an embodiment of the inventive RF measurement system 1 in application (real-time operation) mode. In application mode, the signal processing circuit 17 is parametrized with a pre-existent parameter set 254 which has been stored in the memory 70 in a previous training, or has been uploaded via the user-interface 90 into the memory 70. Depending on a process recipe 258 which may be provided via the user interface 90, for each recipe step a dedicated parameter configuration may be loaded from the memory 70 or from the user interface 90 into the signal processing circuit 17 via the control 80. The signal processing circuit 17 which is parameterized in such way, is then processing input signals in real time which are continuously provided from the RF system, e. g. from sensors in the RF generator 2, the impedance matching network 4, or the plasma process system 3 and digitized in ADCs 30.

Depending on the implemented algorithm or neural network in the programmable circuit 10, the result of the signal processing may then be used to control the signal generation unit 16, e. g. a DDS core, or further circuits 19. The signal generation unit 16 is used to adjust, for example, amplitude, frequency and phase of the RF signal which is converted into an RF power signal by a digital-to-analog converter (DAC) 22 and a power amplifying stage 23. The resulting RF power signal at the output of the RF generator 2 can then be provided via the impedance matching network 4 to the plasma process system 3. In this way, the result of, for example, a filtering of the input signals 210 from the directional coupler 20 at the output of the RF generator 2 can directly be used to adapt the RF power signal in a way that, for example, RF power delivered into the plasma is stabilized, and reflected power from the plasma is minimized.

Additionally, the signal processing circuit 17 may also be configured to monitor the input signals 210 for patterns which indicate certain events or unwanted situations, e. g. a high-voltage discharge in the plasma process system 3, or a degradation of hardware components related to the plasma processing, e. g. particle build-up within the plasma system, or drifting of the plasma impedance indicating that a cleaning or other preventive maintenance of the plasma chamber 31 might be required. Such events can either be flagged 259 to the user via the user interface 90, or directly acted upon by further circuits 19 within the programmable circuit 10 which can trigger corrective actions 250. For example, in the case of an arcing event or a high-voltage discharge, or if a high probability for the occurrence of such an event has been determined by the signal processing, the programmable circuit 10 might initiate a reduction or a complete turn-off of the RF power for a certain period of time. This can be achieved, for example, by reducing the amplitude of the RF signal generated in the signal generation unit 16, or by disabling the DAC 22, or by interrupting the connection between DAC 22 and power amplifying stage 23 for a certain period of time.

The circuit layout of the programmable circuit 10 or the algorithm which is used by the programmable circuit 10 may also be stored in the memory 70, and, depending on the application, different circuit layouts 255 may be implemented in the programmable circuit 10.

As mentioned before for the training mode, also in the application mode, at least part of the control 80 and/or part of the memory 70 may be implemented in the programmable circuit 10. This has the advantage that the switching between different configurations of the signal processing circuit 17 can be accelerated considerably,

The foregoing explanation of the embodiments describes the present invention exclusively in the context of examples. Of course, individual features of the embodiments can be freely combined with each other, provided that this is technically reasonable, without leaving the scope of the present invention.

### List of reference signs

- 1: system
- 2: RF generator
- 3: plasma process system
- 4: matching network
- 5: plasma power system
- 10: circuit
- 11: local oscillator
- 12: multiplication
- 13: digital filter
- 14: elemental operation square
- 15: elemental operation addition
- 16: signal generation unit
- 17: signal processing circuit
- 18: evaluation circuit
- 19: further circuits

- 20: sensor
- 21: DC supply
- 22: digital-to-analog converter (DAC)
- 23: power amplifying stage (PA)

- 30: analog-to-digital converter (ADC)
- 31: plasma chamber
- 32: plasma sensor

- 40: impedance matching circuitry
- 41: input sensor
- 42: match control unit
- 43: output sensor, V/I sensor
- 50: anti-aliasing filter
- 60: transmission line
- 70: memory
- 80: control circuit
- 90: electronic interface, user interface

- 101: Providing at least one input signal, first method step
- 102: performing, second method step
- 103: determining, third method step
- 104: providing the at least one determined parameter result, fourth method step
- 105: Parametrizing, fifth method step
- 106: Sensing, sixth method step
- 107: Performing, seventh method step

- 210: (stored / pre-existent) input signal
- 220: processing result
- 230: (real-time) input signal

- 240: parameter result

- 250: corrective actions
- 251: user parameter sets
- 252a: user reference results
- 252b: user reference input signals
- 253: operation mode
- 254: parameter sets
- 255: circuit layouts
- 256: reference results
- 257: recorded measurement data sets, reference input signals
- 258: process recipe
- 259: event flags

- 310: processing procedure

- A: Amplitude
- I: In-phase portion of the signal
- Q: Out-of-phase portion of the signal
- φ: phase offset

## Claims

1. A method for improving digital signal processing in a radio-frequency system (1), in particular a radio-frequency power delivery system (1), comprising:
- Providing (101) at least one input signal (210), preferably related to a radio-frequency signal of the radio-frequency system (1),
- Performing (102) a processing procedure (310) wherein the at least one input signal (210) is repeatedly processed by a programmable circuit (10) using at least one configurable parameter of the processing, wherein a configuration of the at least one parameter is varied for each processing of the at least one input signal (210) to obtain respective processing results (220),
- Determining (103) at least one parameter result (240) for an optimization of the configuration based on the processing results (220),
- Providing (104) the at least one determined parameter result for the improved digital signal processing
**characterized in that** the method further comprises:
- Parametrizing (105) the same or another programmable circuit (10) using the at least one determined parameter result,
- Sensing (106) the radio-frequency signal of the radio-frequency system (1),
- Performing (107) the digital signal processing by using a processing of the sensed radio-frequency signal at least partially by the parametrized circuit (10),
- Monitoring the radio-frequency signal by repeatedly performing (102) the sensing (106) and the digital signal processing,
wherein the processing procedure (310) is used as a training procedure for performing the parameterization (105) of the programmable circuit (10) in a training mode of the processing using the input signal (210) as a pre-existent training input signal (210), whereas the monitoring is performed in a real-time mode of the processing, in which the radio-frequency signal is sensed and processed as a real-time input signal (230).

2. The method according to claim 1, **characterized in that** the programmable circuit (10) is configured as a programmable integrated circuit (10), preferably a digital signal processor (DSP), a complex programmable logic device (CPLD) or a field programmable gate array (FPGA).

3. The method according to any of the preceding claims, **characterized in that** the at least one input signal (210) processed in the processing procedure (310) is configured as at least one training input signal (210), and the method further comprises:
- Finalizing the parametrization (105) of the programmable circuit (10) by configuring the at least one parameter using the previously determined parameter result, wherein the configuration is subsequently fixed,
- Switching the processing from a training mode to a real-time mode, wherein in the real-time mode a real-time input signal is processed by the programmable circuit (10) in real-time using the fixed configuration, particularly for a filtering of the real-time input signal, wherein preferably the real-time input signal is configured as an actually measured signal received from at least one analog-to-digital converter (30) which converts the radio-frequency signal sensed by at least one sensor (20) to the at least one real-time input signal,
- Switching the processing from the real-time mode to the training mode, wherein in the training mode the existing and previously fixed configuration is further optimized by carrying out the processing procedure (310) again using at least one additional training input signal (210) as the training input signal (210) to newly determine the at least one parameter result, wherein, depending on a comparison of the newly determined parameter result with the previously determined parameter result, a re-parametrization of the programmable circuit (10) is performed by configuring the at least one parameter using the newly determined parameter result.

4. The method according to any of the preceding claims, **characterized in that** the repeatedly processing of the at least one input signal (210) is carried out by repeated processing steps, where for each step the same at least one input signal (210) is processed by the same programmable circuit (10), while using the varied configurations of the at least one parameter, so that the respective processing results (220) are specific for and/or assigned to the varied configurations, and wherein
the at least one input signal (210) is provided as one or a plurality of predetermined reference input signals (210), for each of which a reference result is provided that represents a desired result of the processing of the corresponding input signal (210), and the determining (103) the at least one parameter result for an optimization of the configuration based on the processing results (220) comprises:
- Evaluating the varied configurations by comparing each of the obtained processing results (220) for the at least one reference input signal (210) with the corresponding reference result, wherein the evaluation depends on the matching of the processing result (220) with the reference result.

5. The method according to claim 4, **characterized in that** the determining (103) the at least one parameter result for optimizing the configuration based on the processing results (220) comprises:
- Selecting the at least one configuration with the highest evaluation as the at least one determined parameter result,
and the providing (104) the at least one determined parameter result for the improved digital signal processing comprises:
- Parametrizing (105) the same or another programmable circuit (10) using the at least one selected configuration,
wherein preferably said at least one predetermined reference input signal (210) and the corresponding reference results comprise a plurality of predetermined reference input signals (210) and corresponding reference results for different applications of the digital signal processing, so that determining said at least one parameter result for optimizing the configuration based on the processing results (220) is performed separately for each application, and the providing (104) the at least one determined parameter result comprises storing the selected configurations in a memory (70), wherein the parametrizing the same or another programmable circuit (10) comprises selecting the configuration used from the stored configurations depending on the application.

6. The method according to any of the preceding claims, **characterized in that** the at least one input signal (210) is configured as multiple pre-existing input signals (210), wherein the processing procedure (310) comprises repeated processing steps, wherein each processing step comprises:
- Processing the same input signals (210) one after another,
- Setting the configuration of the used at least one parameter in this processing step by a control circuit (80),
the method further comprising:
- Evaluating, after each processing step, a deviation of the processing result (220) from a predetermined reference result by the control circuit (80),
- Modifying, after each evaluation, the configuration of the used at least one parameter for the next processing step based on said evaluation,
wherein the control circuit (80) is electrically connected to the programmable circuit (10) and configured separately from the programmable circuit (10), and wherein the configuration of the used at least one parameter vary for different processing steps to iteratively optimize the configuration for the improved digital signal processing.

7. The method according to any of the preceding claims, **characterized in that** the processing procedure (310) is configured as a training procedure for the optimization of the configuration in an iterative manner for different specific situations in the application of the radio-frequency system (1), so that the parameter results determined for the different situations are configured as different optimized parameter sets for these different situations.

8. The method according to any of the preceding claims, **characterized in that** the at least one input signal (210) comprises a temporal signal course, preferably momentary and historical values, particularly measurement values of the radio-frequency signals, and the processing result is obtained by the processing of the signal course to indicate a probability for the detection of a specific pattern in the signal course.

9. The method according to any of the preceding claims, **characterized in that** an electronic interface is provided to carry out an upload of the at least one input signal (210) to the programmable circuit (10), wherein the at least one input signal (210) is configured as a plurality of input signals (210), which are stored in a memory (70) after uploading.

10. The method according to any of the preceding claims, **characterized in that** the at least one input signal (210) is configured as at least one thousand or at least one million different input signals (210), wherein each of the input signals represents at least one waveform related to the radio-frequency signal, wherein the processing is intended to evaluate the waveform depending on the parameter configuration, whereby the respective processing results (220) comprise a result of said evaluation.

11. The method according to any of the preceding claims, **characterized in that** the programmable circuit (10) comprises logic elements for decomposing the input signal (210) into amplitude and phase using an algorithm, wherein the algorithm is parametrized by the varied configurations.

12. The method according to any of the preceding claims, **characterized in that** an evaluation of the varied configurations is carried out by comparing each of the processing results (220) associated with the varied configurations with a predetermined reference result, wherein the predetermined reference result comprises a predetermined ideal result of an algorithm that is carried out by the programmable circuit (10).

13. The method according to any of the preceding claims, **characterized in that** the method further comprises:
- Uploading a pre-existent configuration via an electronic interface (90), particularly into the programmable circuit (10) or into the control unit (80) or into the memory (70),
- Parametrizing (105) the programmable circuit (10) using the pre-existent configuration.

14. The method according to claim 12, **characterized in that** the uploaded pre-existent configuration is stored in the same memory (80) and/or in a different memory and/or the uploaded pre-existent configuration overwrites any of the configurations according to one of the claims 1 - 12.

15. A radio-frequency power delivery system (1) or a radio-frequency plasma system, comprising:
- at least one sensor (20), particularly a directional coupler or a current-voltage sensor or a plasma sensor, for sensing a radio-frequency signal of the radio-frequency power delivery system (1) or the radio-frequency plasma system, respectively,
- at least one analog-to-digital converter (30) for converting the at least one sensed radio-frequency signal into an at least one input signal (210, 230),
- a circuit (10) for a digital signal processing of the at least one input signal (210, 230),
**characterized in that** the circuit (10) is parameterized by the at least one parameter result determined according to a method according to any of the preceding claims.

16. The system according to claim 15, **characterized in that** the system further comprises an electronic interface (90) for uploading a pre-existent configuration into the programmable circuit (10) or into the control unit (80) or into the memory (70) for the parameterizing of the circuit (10).

17. The system according to claim 16, **characterized in that** the electronic interface (90) is electronically connected with the control unit (80) or the memory (70) or the programmable circuit (10) for performing the uploading using a direct data transfer.

## Patentansprüche

1. Verfahren zur Verbesserung der digitalen Signalverarbeitung in einem Hochfrequenzsystem (1), insbesondere einem Hochfrequenzenergieversorgungssystem (1), mit den Schritten:
- Bereitstellen (101) mindestens eines Eingangssignals (210), vorzugsweise bezogen auf ein Hochfrequenzsignal des Hochfrequenzsystems (1),
- Durchführen (102) eines Verarbeitungsvorgangs (310), wobei das mindestens eine Eingangssignal (210) von einer programmierbaren Schaltung (10) unter Verwendung mindestens eines konfigurierbaren Parameters der Verarbeitung wiederholt verarbeitet wird, wobei eine Konfiguration des mindestens einen Parameters für jede Verarbeitung des mindestens einen Eingangssignals (210) variiert wird, um jeweilige Verarbeitungsergebnisse (220) zu erhalten,
- Ermitteln (103) mindestens eines Parameterergebnisses (240) für eine Optimierung der Konfiguration basierend auf den Verarbeitungsergebnissen (220),
- Bereitstellen (104) des mindestens einen ermittelten Parameterergebnisses für die verbesserte digitale Signalverarbeitung,
**dadurch gekennzeichnet, dass** das Verfahren ferner die folgenden Schritte aufweist:
- Parametrisieren (105) derselben oder einer anderen programmierbaren Schaltung (10) unter Verwendung des mindestens einen ermittelten Parameterergebnisses,
- Erfassen (106) des Hochfrequenzsignals des Hochfrequenzsystems (1),
- Durchführen (107) der digitalen Signalverarbeitung unter Verwendung einer Verarbeitung des erfassten Hochfrequenzsignals zumindest teilweise durch die parametrisierte Schaltung (10),
- Überwachen des Hochfrequenzsignals durch wiederholtes Durchführen (102) des Erfassens (106) und der digitalen Signalverarbeitung,
wobei der Verarbeitungsvorgang (310) als Trainingsvorgang für die Durchführung der Parametrisierung (105) der programmierbaren Schaltung (10) in einem Trainingsmodus der Verarbeitung verwendet wird, wobei das Eingangssignal (210) als ein vorexistierendes Trainingseingangssignal (210) verwendet wird, während das Überwachen in einem Echtzeitmodus der Verarbeitung durchgeführt wird, in welchem das Hochfrequenzsignal erfasst und als ein Echtzeit-Eingangssignal verarbeitet wird.

2. Verfahren nach Anspruch 1, **dadurch gekennzeichnet, dass** die programmierbare Schaltung (10) als eine programmierbare integrierte Schaltung (10), vorzugsweise ein digitaler Signalprozessor (DSP), eine komplexe programmierbare Logikvorrichtung (CPLD) oder ein Field Programmable Gate Array (FPGA) ausgebildet ist.

3. Verfahren nach einem der vorhergehenden Ansprüche, **dadurch gekennzeichnet, dass** das in dem Verarbeitungsvorgang verarbeitete mindestens eine Eingangssignal (210) als mindestens ein Trainings-Eingangssignal (210) ausgebildet ist, und das Verfahren ferner die folgenden Schritte aufweist:
- Finalisieren der Parametrisierung (105) der programmierbaren Schaltung (10) durch Konfigurieren des mindestens einen Parameters unter Verwendung des zuvor ermittelten Parameterergebnisses, wobei die Konfiguration anschließend fixiert wird,
- Wechseln der Verarbeitung von einem Trainingsmodus zu einem Echtzeitmodus, wobei im Echtzeitmodus ein Echtzeit-Eingangssignal durch die programmierbare Schaltung (10) unter Verwendung der fixierten Konfiguration in Echtzeit verarbeitet wird, insbesondere für ein Filtern des Echtzeit-Eingangssignals, wobei vorzugsweise das Echtzeit-Eingangssignal als ein tatsächlich gemessenes Signal ausgebildet ist, das von mindestens einem Analog-Digital-Wandler (30) empfangen wird, welcher das von mindestens einem Sensor (20) erfasste Hochfrequenzsignal in das mindestens eine Echtzeit-Eingangssignal umwandelt,
- Wechseln der Verarbeitung von dem Echtzeitmodus zum Trainingsmodus, wobei im Trainingsmodus die existierende und zuvor fixierte Konfiguration durch erneutes Ausführen des Verarbeitungsvorgangs (310) unter Verwendung mindestens eines zusätzlichen Trainings-Eingangssignals (210) als das Trainings-Eingangssignal (210) weiter optimiert wird, um das mindestens eine Parameterergebnis neu zu ermitteln, wobei in Abhängigkeit von einem Vergleich des neu ermittelten Parameterergebnisses mit dem zuvor ermittelten Parameterergebnis, eine Re-Parametrisierung der programmierbaren Schaltung (10) durch Konfigurieren des mindestens einen Parameters unter Verwendung des neu ermittelten Parameterergebnisses durchgeführt wird.

4. Verfahren nach einem der vorhergehenden Ansprüche, **dadurch gekennzeichnet, dass** das wiederholte Verarbeiten des mindestens einen Eingangssignals (210) durch wiederholte Verarbeitungsschritte durchgeführt wird, wobei in jedem Schritt dasselbe mindestens eine Eingangssignal (210) von derselben programmierbaren Schaltung (10) unter Verwendung der verschiedenen Konfigurationen des mindestens einen Parameters verarbeitet wird, so dass die jeweiligen Verarbeitungsergebnisse (220) für die verschiedenen Konfigurationen spezifisch sind und/oder diesen zugeordnet sind, und wobei
das mindestens eine Eingangssignal (210) als ein oder mehrere vorbestimmte Referenz-Eingangssignale (210) vorgesehen ist, wobei für jedes ein Referenzergebnis gegeben ist, das ein gewünschtes Ergebnis der Verarbeitung des entsprechenden Eingangssignals (210) repräsentiert, und das Ermitteln (103) des mindestens einen Parameterergebnisses für eine Optimierung der Konfiguration basierend auf den Verarbeitungsergebnissen (220) den folgenden Schritt aufweist:
- Bewerten der verschiedenen Konfigurationen durch Vergleichen jedes der erhaltenen Verarbeitungsergebnisse (220) für das mindestens eine Referenz-Eingangssignal (210) mit dem entsprechenden Referenzergebnis, wobei die Bewertung von der Übereinstimmung des Verarbeitungsergebnisses (220) mit dem Referenzergebnis abhängt.

5. Verfahren nach Anspruch 4, **dadurch gekennzeichnet, dass** das Ermitteln (103) des mindestens einen Parameterergebnisses zur Optimierung der Konfiguration basierend auf den Verarbeitungsergebnissen (220) den folgenden Schritt aufweist:
- Wählen der mindestens einen Konfiguration mit der höchsten Bewertung als das mindestens eine ermittelte Parameterergebnis,
und das Bereitstellen (104) des mindestens einen ermittelten Parameterergebnisses für die verbesserte digitale Signalverarbeitung den folgenden Schritt aufweist:
- Parametrisieren (105) derselben oder einer anderen programmierbaren Schaltung (10) unter Verwendung der mindestens einen gewählten Konfiguration,
wobei vorzugsweise das mindestens eine vorbestimmte Referenzeingangssignal (210) und die entsprechenden Referenzergebnisse mehrere vorbestimmte Referenz-Eingangssignale (210) und entsprechende Referenzergebnisse für verschiedene Anwendungen der digitalen Signalverarbeitung aufweisen, so dass das Ermitteln des mindestens einen Parameterergebnisses zur Optimierung der Konfiguration basierend auf den Verarbeitungsergebnissen (220) für jede Anwendung separat durchgeführt wird, und das Bereitstellen (104) des mindestens einen ermittelten Parameterergebnisses das Speichern der gewählte Konfigurationen in einem Speicher (70) aufweist, wobei das Parametrisieren derselben oder einer anderen programmierbaren Schaltung (10) das Wählen der verwendeten Konfiguration aus den gespeicherten Konfigurationen in Abhängigkeit von der Anwendung aufweist.

6. Verfahren nach einem der vorhergehenden Ansprüche, **dadurch gekennzeichnet, dass** das mindestens eine Eingangssignal (210) als mehrere vorexistente Eingangssignale (210) ausgebildet ist, wobei der Verarbeitungsvorgang (310) wiederholte Verarbeitungsschritte aufweist, wobei jeder Verarbeitungsschritt aufweist:
- Verarbeiten derselben Eingangssignale (210) nacheinander,
- Einstellen der Konfiguration des verwendeten mindestens einen Parameters in diesem Verarbeitungsschritt durch eine Steuerschaltung (80),
wobei das Verfahren ferner die folgenden Schritte aufweist:
- Bewerten, nach jedem Verarbeitungsschritt, einer Abweichung des Verarbeitungsergebnisses (220) von einem vorbestimmten Referenzergebnis durch die Steuerschaltung (80),
- Modifizieren, nach jeder Bewertung, der Konfiguration des verwendeten mindestens einen Parameters für den nächsten Verarbeitungsschutz basierend auf der Bewertung,
wobei die Steuerschaltung (80) mit der programmierbaren Schaltung (10) elektrisch verbunden ist und separat von der programmierbaren Schaltung (10) konfiguriert ist, und
wobei die Konfiguration des verwendeten mindestens einen Parameters für verschiedene Verarbeitungsschritte variiert, um die Konfiguration für die verbesserte digitale Signalverarbeitung iterativ zu optimieren.

7. Verfahren nach einem der vorhergehenden Ansprüche, **dadurch gekennzeichnet, dass** der Verarbeitungsvorgang (310) als ein Trainingsvorgang für die Optimierung der Konfiguration auf iterative Weise für verschiedene spezifische Situationen in der Anwendung des Hochfrequenzsystems (1) ausgebildet ist, so dass die für die verschiedenen Situationen ermittelten Parameterergebnisse als verschiedene optimierte Parametersätze für diese verschiedenen Situationen konfiguriert sind.

8. Verfahren nach einem der vorhergehenden Ansprüche, **dadurch gekennzeichnet, dass** das mindestens eine Eingangssignal (210) einen zeitlichen Signalverlauf aufweist, vorzugsweise momentane und historische Werte, insbesondere Messwerte der Hochfrequenzsignale, und das Verarbeitungsergebnis durch das Verarbeiten des Signalverlaufs erhalten wird, um eine Wahrscheinlichkeit der Erkennung eines spezifischen Musters im Signalverlauf anzugeben.

9. Verfahren nach einem der vorhergehenden Ansprüche, **dadurch gekennzeichnet, dass** ein elektronisches Interface vorgesehen ist, um ein Hochladen des mindestens einen Eingangssignals (210) in die programmierbare Schaltung (10) durchzuführen, wobei das mindestens eine Eingangssignal (210) als mehrere Eingangssignale (210) ausgebildet sind, welche nach dem Hochladen in einem Speicher (70) gespeichert werden.

10. Verfahren nach einem der vorhergehenden Ansprüche, **dadurch gekennzeichnet, dass** das mindestens eine Eingangssignal (210) als mindestens eintausend oder mindestens eine Million verschiedene Eingangssignale (210) ausgebildet ist, wobei jedes der Eingangssignale mindestens eine Wellenform auf das Hochfrequenzsignal bezogene Wellenform aufweist, wobei die Verarbeitung der Bewertung der Wellenform in Abhängigkeit von der Parameterkonfiguration dient, wodurch die jeweiligen Verarbeitungsergebnisse (220) ein Ergebnis dieser Bewertung aufweisen.

11. Verfahren nach einem der vorhergehenden Ansprüche, **dadurch gekennzeichnet, dass** die programmierbare Schaltung (10) Logikelemente zum Zerlegen des Eingangssignals (210) in Amplitude und Phase unter Verwendung eines Algorithmus aufweist, wobei der Algorithmus durch die verschiedenen Konfigurationen parametrisiert ist.

12. Verfahren nach einem der vorhergehenden Ansprüche, **dadurch gekennzeichnet, dass** eine Bewertung der verschiedenen Konfigurationen durch Vergleichen jedes der den verschiedenen Konfigurationen zugeordneten Verarbeitungsergebnisse (220) mit einem vorbestimmten Referenzergebnis erfolgt, wobei das vorbestimmte Referenzergebnis ein vorbestimmtes Idealergebnis eines Algorithmus aufweist, der von der programmierbaren Schaltung (10) ausgeführt wird.

13. Verfahren nach einem der vorhergehenden Ansprüche, **dadurch gekennzeichnet, dass** das Verfahren ferner die folgenden Schritte aufweist:
- Hochladen einer vorexistierenden Konfiguration über ein elektronisches Interface (90) insbesondere in die programmierbare Schaltung (10) oder in die Steuereinheit (80) oder in den Speicher (70),
- Parametrisieren (105) der programmierbaren Schaltung (10) unter Verwendung der vorexistierenden Konfiguration.

14. Verfahren nach Anspruch 12, **dadurch gekennzeichnet, dass** die hochgeladene vorexistierende Konfiguration in demselben Speicher (80) und oder in einem anderen Speicher gespeichert wird und/oder die hochgeladene vorexistierende Konfiguration jede der Konfigurationen nach einem der Ansprüche 1-12 überschreibt.

15. Hochfrequenzenergieversorgungssystem (1) oder Hochfrequenzplasmasystem mit:
- mindestens einem Sensor (20), insbesondere einem Richtkoppler oder einem Strom-Spannungssensor oder einem Plasmasensor, zum Erfassen eines Hochfrequenzsignals des Hochfrequenzenergieversorgungssystems (1) beziehungsweise des Hochfrequenzplasmasystems,
- mindestens einem Analog/Digitalwandler (30) zum Umwandeln des mindestens einen erfassten Hochfrequenzsignals in mindestens ein Eingangssignal (210, 230),
- einer Schaltung (10) für eine digitale Signalverarbeitung des mindestens einen Eingangssignals (210, 230),
**dadurch gekennzeichnet, dass** die Schaltung (10) durch das mindestens eine gemäß einem Verfahren nach einem der vorhergehenden Ansprüche ermittelte Parameterergebnis parametrisiert ist.

16. System nach Anspruch 15, **dadurch gekennzeichnet, dass** das System ferner ein elektronisches Interface (90) zum Hochladen einer vorexistierenden Konfiguration in die programmierbare Schaltung (10) oder in die Steuereinheit (80) oder in den Speicher (70) für das Parametrisieren der Schaltung (10) aufweist.

17. System nach Anspruch 16, **dadurch gekennzeichnet, dass** das elektronische Interface (90) elektronisch mit der Steuereinheit (80) oder dem Speicher (70) oder der programmierbaren Schaltung (10) verbunden, um das Hochladen unter Verwendung eines direkten Datentransfers durchzuführen.

## Revendications

1. Procédé permettant d'améliorer un traitement de signal numérique dans un système radiofréquence (1), en particulier un système de distribution de puissance radiofréquence (1), comprenant :
- la fourniture (101) d'au moins un signal d'entrée (210), de préférence apparenté à un signal radiofréquence du système radiofréquence (1),
- la mise en œuvre (102) d'une procédure de traitement (310) dans lequel l'au moins un signal d'entrée (210) est traité de manière répétée par un circuit programmable (10) à l'aide d'au moins un paramètre configurable du traitement, dans lequel une configuration de l'au moins un paramètre est variée pour chaque traitement de l'au moins un signal d'entrée (210) pour obtenir des résultats de traitement (220) respectifs,
- la détermination (103) d'au moins un résultat de paramètre (240) pour une optimisation de la configuration en fonction des résultats de traitement (220),
- la fourniture (104) de l'au moins un résultat de paramètre déterminé pour le traitement amélioré de signal numérique
**caractérisé en ce que** le procédé comprend en outre :
- le paramétrage (105) du même ou d'un autre circuit programmable (10) à l'aide de l'au moins un résultat de paramètre déterminé,
- le captage (106) du signal radiofréquence du système radiofréquence (1),
- la mise en œuvre (107) du traitement de signal numérique en utilisant un traitement du signal radiofréquence capté au moins partiellement par le circuit paramétré (10),
- la surveillance du signal radiofréquence en mettant en œuvre (102) de manière répétée le captage (106) et le traitement de signal numérique,
dans lequel la procédure de traitement (310) est utilisée en tant que procédure d'entraînement permettant de mettre en œuvre le paramétrage (105) du circuit programmable (10) dans un mode d'entraînement du traitement à l'aide du signal d'entrée (210) en tant que signal d'entrée (210) d'entraînement préexistant, alors que la surveillance est mise en œuvre dans un mode en temps réel du traitement, dans lequel le signal radiofréquence est capté et traité en tant que signal d'entrée en temps réel (230).

2. Procédé selon la revendication 1, **caractérisé en ce que** le circuit programmable (10) est configuré en tant que circuit intégré programmable (10), de préférence un processeur de signal numérique (DSP), un dispositif logique programmable complexe (CPLD) ou un réseau prédiffusé programmable par l'utilisateur (FPGA).

3. Procédé selon l'une quelconque des revendications précédentes, **caractérisé en ce que** l'au moins un signal d'entrée (210) traité dans la procédure de traitement (310) est configuré en tant qu'au moins un signal d'entrée (210) d'entraînement, et le procédé comprend en outre :
- la finalisation du paramétrage (105) du circuit programmable (10) en configurant l'au moins un paramètre à l'aide du résultat de paramètre précédemment déterminé, dans lequel la configuration est ultérieurement fixée,
- la commutation du traitement d'un mode d'entraînement à un mode en temps réel, dans lequel dans le mode en temps réel un signal d'entrée en temps réel est traité par le circuit programmable (10) en temps réel à l'aide de la configuration fixée, en particulier pour un filtrage du signal d'entrée en temps réel, dans lequel de préférence le signal d'entrée en temps réel est configuré en tant que signal réellement mesuré reçu d'au moins un convertisseur analogique vers numérique (30) qui convertit le signal radiofréquence capté par au moins un capteur (20) en l'au moins un signal d'entrée en temps réel,
- la commutation du traitement du mode en temps réel au mode d'entraînement, dans lequel dans le mode d'entraînement la configuration existante et précédemment fixée est davantage optimisée en effectuant la procédure de traitement (310) de nouveau à l'aide d'au moins un signal d'entrée (210) d'entraînement supplémentaire en guise de signal d'entrée (210) d'entraînement pour déterminer à nouveau l'au moins un résultat de paramètre, dans lequel, en dépendance d'une comparaison du résultat de paramètre nouvellement déterminé au résultat de paramètre précédemment déterminé, un reparamétrage du circuit programmable (10) est mis en œuvre en configurant l'au moins un paramètre à l'aide du résultat de paramètre nouvellement déterminé.

4. Procédé selon l'une quelconque des revendications précédentes, **caractérisé en ce que** le traitement répété de l'au moins un signal d'entrée (210) est effectué par des étapes de traitement répétées, où pour chaque étape le même au moins un signal d'entrée (210) est traité par le même circuit programmable (10), tout en utilisant les configurations variées de l'au moins un paramètre, de sorte que les résultats de traitement (220) respectifs sont spécifiques pour les et/ou attribués aux configurations variées, et dans lequel
l'au moins un signal d'entrée (210) est fourni en tant qu'un ou une pluralité de signaux d'entrée (210) de référence prédéterminés, pour chacun desquels un résultat de référence est fourni lequel représente un résultat souhaité du traitement du signal d'entrée (210) correspondant, et la détermination (103) de l'au moins un résultat de paramètre pour une optimisation de la configuration en fonction des résultats de traitement (220) comprend :
- l'évaluation des configurations variées en comparant chacun des résultats de traitement (220) obtenus pour l'au moins un signal d'entrée (210) de référence au résultat de référence correspondant, dans lequel l'évaluation dépend d'une concordance du résultat de traitement (220) avec le résultat de référence.

5. Procédé selon la revendication 4, **caractérisé en ce que** la détermination (103) de l'au moins un résultat de paramètre permettant d'optimiser la configuration en fonction des résultats de traitement (220) comprend :
- la sélection de l'au moins une configuration avec l'évaluation la plus élevée en guise d'au moins un résultat de paramètre déterminé,
et la fourniture (104) de l'au moins un résultat de paramètre déterminé pour le traitement amélioré de signal numérique comprend :
- le paramétrage (105) du même ou d'un autre circuit programmable (10) à l'aide de l'au moins une configuration sélectionnée,
dans lequel de préférence ledit au moins un signal d'entrée (210) de référence prédéterminé et le résultat de référence correspondant comprennent une pluralité de signaux d'entrée (210) de référence prédéterminés et des résultats de référence correspondants pour des applications différentes du traitement de signal numérique, de sorte que la détermination dudit au moins un résultat de paramètre permettant d'optimiser la configuration en fonction des résultats de traitement (220) est mise en œuvre séparément pour chaque application, et la fourniture (104) de l'au moins un résultat de paramètre déterminé comprend le stockage des configurations sélectionnées dans une mémoire (70), dans lequel le paramétrage du même ou d'un autre circuit programmable (10) comprend la sélection de la configuration utilisée parmi les configurations stockées en dépendance de l'application.

6. Procédé selon l'une quelconque des revendications précédentes, **caractérisé en ce que** l'au moins un signal d'entrée (210) est configuré en tant que signaux d'entrée (210) préexistants multiples, dans lequel la procédure de traitement (310) comprend des étapes de traitement répétées, dans lequel chaque étape de traitement comprend :
- le traitement des mêmes signaux d'entrée (210) l'un après l'autre,
- le réglage de la configuration de l'au moins un paramètre utilisé dans cette étape de traitement par un circuit de commande (80),
le procédé comprenant en outre :
- l'évaluation, après chaque étape de traitement, d'une déviation du résultat de traitement (220) par rapport à un résultat de référence prédéterminé par le circuit de commande (80),
- la modification, après chaque évaluation, de la configuration de l'au moins un paramètre utilisé pour l'étape de traitement suivante en fonction de ladite évaluation,
dans lequel le circuit de commande (80) est connecté électriquement au circuit programmable (10) et configuré séparément du circuit programmable (10), et dans lequel la configuration de l'au moins un paramètre utilisé varie pour différentes étapes de traitement pour optimiser itérativement la configuration pour le traitement amélioré de signal numérique.

7. Procédé selon l'une quelconque des revendications précédentes, **caractérisé en ce que** la procédure de traitement (310) est configurée en tant que procédure d'entraînement pour l'optimisation de la configuration d'une manière itérative pour différentes situations spécifiques dans l'application du système radiofréquence (1), de sorte que les résultats de paramètre déterminés pour les différentes situations sont configurés en tant qu'ensembles de paramètres optimisés différents pour ces différentes situations.

8. Procédé selon l'une quelconque des revendications précédentes, **caractérisé en ce que** l'au moins un signal d'entrée (210) comprend un parcours de signal temporel, de préférence des valeurs momentanées et historiques, en particulier des valeurs de mesure des signaux radiofréquence, et le résultat de traitement est obtenu par le traitement du parcours de signal pour indiquer une probabilité de détection d'un motif spécifique dans le parcours de signal.

9. Procédé selon l'une quelconque des revendications précédentes, **caractérisé en ce qu'**une interface électronique est fournie pour effectuer un téléversement de l'au moins un signal d'entrée (210) vers le circuit programmable (10), dans lequel l'au moins un signal d'entrée (210) est configuré en tant que pluralité de signaux d'entrée (210), qui sont stockés dans une mémoire (70) après téléversement.

10. Procédé selon l'une quelconque des revendications précédentes, **caractérisé en ce que** l'au moins un signal d'entrée (210) est configuré en tant qu'au moins un millier ou au moins un million de signaux d'entrée (210) différents, dans lequel chacun des signaux d'entrée représente au moins une forme d'onde apparentée au signal radiofréquence, dans lequel le traitement est prévu pour évaluer la forme d'onde en dépendance de la configuration de paramètres, moyennant quoi les résultats de traitement (220) respectifs comprennent un résultat de ladite évaluation.

11. Procédé selon l'une quelconque des revendications précédentes, **caractérisé en ce que** le circuit programmable (10) comprend des éléments logiques permettant de décomposer le signal d'entrée (210) en amplitude et en phase à l'aide d'un algorithme, dans lequel l'algorithme est paramétré par les configurations variées.

12. Procédé selon l'une quelconque des revendications précédentes, **caractérisé en ce qu'**une évaluation des configurations variées est effectuée en comparant chacun des résultats de traitement (220) associés aux configurations variées à un résultat de référence prédéterminé, dans lequel le résultat de référence prédéterminé comprend un résultat idéal prédéterminé d'un algorithme exécuté par le circuit programmable (10).

13. Procédé selon l'une quelconque des revendications précédentes, **caractérisé en ce que** le procédé comprend en outre :
- le téléversement d'une configuration préexistante par l'intermédiaire d'une interface électronique (90), en particulier vers le circuit programmable (10) ou vers l'unité de commande (80) ou vers la mémoire (70),
- le paramétrage (105) du circuit programmable (10) à l'aide de la configuration préexistante.

14. Procédé selon la revendication 12, **caractérisé en ce que** la configuration préexistante téléversée est stockée dans la même mémoire (80) et/ou dans une mémoire différente et/ou la configuration préexistante téléversée écrase l'une quelconque des configurations selon l'une des revendications 1 à 12.

15. Système de distribution de puissance radiofréquence (1) ou système radiofréquence plasma, comprenant :
- au moins un capteur (20), en particulier un coupleur directionnel ou un capteur de courant-tension ou un capteur plasma, permettant de capter un signal radiofréquence du système de distribution de puissance radiofréquence (1) ou du système radiofréquence plasma, respectivement,
- au moins un convertisseur analogique vers numérique (30) permettant de convertir l'au moins un signal de radiofréquence capté en au moins un signal d'entrée (210, 230),
- un circuit (10) permettant un traitement de signal numérique de l'au moins un signal d'entrée (210, 230),
**caractérisé en ce que** le circuit (10) est paramétré par l'au moins un résultat de paramètre déterminé selon un procédé selon l'une quelconque des revendications précédentes.

16. Système selon la revendication 15, **caractérisé en ce que** le système comprend en outre une interface électronique (90) permettant de téléverser une configuration préexistante dans le circuit programmable (10) ou dans l'unité de commande (80) ou dans la mémoire (70) pour le paramétrage du circuit (10).

17. Système selon la revendication 16, **caractérisé en ce que** l'interface électronique (90) est électroniquement connectée à l'unité de commande (80) ou à la mémoire (70) ou au circuit programmable (10) pour la mise en œuvre du téléversement à l'aide d'un transfert direct de données.
